(19) Europäisches Patentamt
European Patent Office
Office européen des brevets

(11) **EP 2 555 005 A2**

(12) **EUROPÄISCHE PATENTANMELDUNG**

(43) Veröffentlichungstag:
**06.02.2013 Patentblatt 2013/06**

(51) Int Cl.:
**G01R 27/26** *(2006.01)*   **G01N 27/02** *(2006.01)*

(21) Anmeldenummer: **12005226.1**

(22) Anmeldetag: **17.07.2012**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**

(30) Priorität: **01.08.2011   DE 102011109127**

(71) Anmelder:
• **Sedlmeyer, Axel
  82131 Gauting (DE)**

• **Sedlmeyer, Felix
  82131 Gauting (DE)**

(72) Erfinder:
• **Sedlmeyer, Axel
  82131 Gauting (DE)**
• **Sedlmeyer, Felix
  82131 Gauting (DE)**

(74) Vertreter: **Kern, Gerbert
  Okenstrasse 11
  77652 Offenburg (DE)**

(54) **Verfahren, Messschaltung und Messeinrichtung zur Messung der dielektrischen Eigenschaften von leitenden Medien**

(57)   Vorgeschlagen werden ein Messverfahren und eine Vorrichtung zur kapazitiven Messung der dielektrischen Eigenschaften von leitenden Stoffen. Die Grundidee ist, mit ZEIGERDIAGRAMMEN komplexer Größen zu arbeiten, die aus geeigneten Ersatzschaltbildern der Messzelle abgeleitet werden. Diese Ersatzschaltbilder werden durch geeignete Beschaltung der Messzelle und Rechenmaßnahmen so modifiziert, dass die gesuchten Eigenschaften des Dielektrikums insbesondere bei niedrigen Frequenzen < 1 kHz dann aus den resultierenden ZEIGERDIAGRAMMEN bestimmt werden können

Fig. 2d1

**Beschreibung**

Technisches Gebiet: Die Anmeldung betrifft ein Messverfahren sowie die zugehörigen Messschaltungen und Messeinrichtungen zur kapazitiven Messung der dielektrischen Eigenschaften wie z.B. bei ionenhaltigen Flüssigkeiten, geladenen Molekülen in wässrigen Lösungen, Elektrolyten, Gelen und ähnlichen Stoffen, das insbesondere bei niedrigen Frequenzen < 1 kHz anwendbar ist.

Stand der Technik: Es sind Verfahren bekannt, bei denen die kapazitive Impedanz zur Bestimmung der Kapazität der Probe in einer Messbrücke ermittelt wird. Aus dieser gemessenen Kapazität wird dann auf die Dielektrizitätskonstante $\varepsilon$ zurückgerechnet [Lit. 1].

Mittels direkter Messung der Phasenverschiebung zwischen Strom und Spannung bietet die Fa. TA Instruments (e-mail: info@tainst.com) eine aufwendige Messanlage an, die für den Laborbetrieb, aber nicht für den Einsatz in verfahrenstechnischen Prozessen gedacht ist.

Eine weitere Möglichkeit bieten bekannte Verfahren, die aus der Relaxations-Zeitkonstanten t die Dielektrizitätskonstante $\varepsilon$ berechnen [Lit. 2].

Aufgabenstellung: Diese bekannten Verfahren haben jedoch den Nachteil, dass eine zuverlässige, einfache Bestimmung der Dielektrizitätskonstante bei größerer Leitfähigkeit des Dielektrikums nur bei höheren Messfrequenzen > 50 kHz funktioniert [Lit. 3]. So bleibt der Anwendungsbereich dieser Geräte auf schwach leitende Polymere und Flüssigkeiten wie z. B. Ölemulsionen beschränkt.

Es gibt aber insbesondere im Bereich der Chemie und Lebensmittelchemie eine Vielzahl von Lösungen mit großen Molekülen, deren Eigenschaften man am besten über die Änderung der Dielektrizitätskonstante bei einer Messung mit tiefen Frequenzen feststellen kann. Für tiefe Frequenzen liefern die bekannten Messverfahren jedoch nicht die nötige Empfindlichkeit und berücksichtigen nicht alle auftretenden Effekte [Lit. 4], um Aussagen über die Eigenschaften der Moleküle in entsprechenden Stoffen machen zu können.

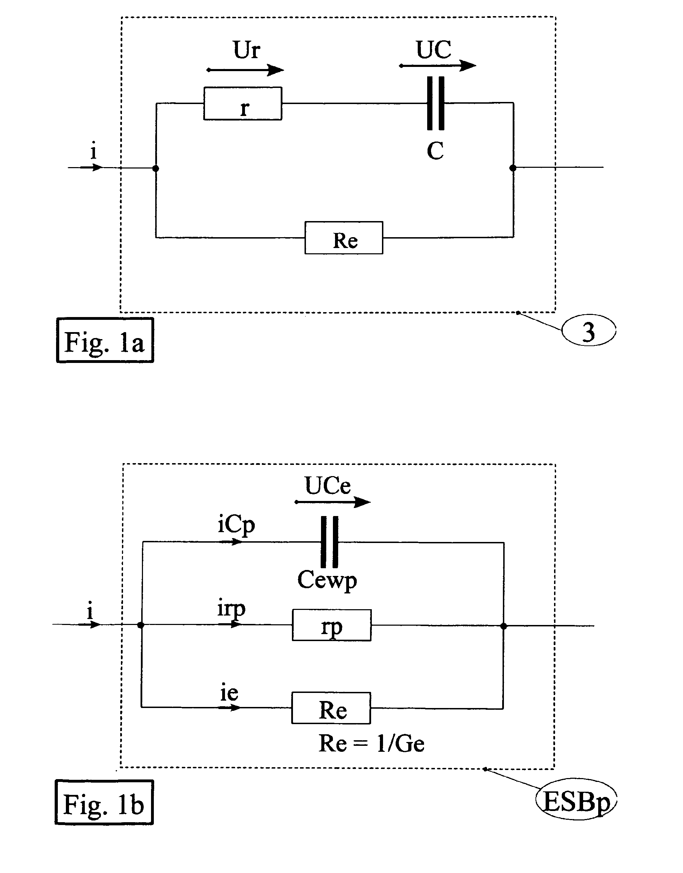

Dies wird klar, wenn man sich ein einfaches, in Fig. 1a gezeigtes Ersatzschaltbild (ESB) für diese Art von Stoffen vor Augen führt: Hierbei ist C die Kapazität, die sich aus der Anordnung ergibt, wenn zwei getrennte Elektroden z.B. in eine Flüssigkeit (Dielektrikum) wie Wasser, Lösungsmittel, Gel, Emulsion etc. eintauchen. r ist der Reihenverlustwiderstand dieser Kapazität C. Re ist der Leitungsverlustwiderstand, da das Dielektrikum keinen idealen Isolator darstellt.

Für eine Messspannung mit höheren Frequenzen liegt der kapazitive Widerstand von dieser allgemein als RC-Glied bezeichneten Anordnung in der Größenordnung des ohmschen Parallelwiderstandes. Bei einem bekannten R und der Geometrie von C ist es dann möglich, mit den aus dem Stand der Technik bekannten Messmethoden auf das $\varepsilon$ mit hinreichender Genauigkeit zurückzurechnen.

Ist die Messspannung jedoch eine niederfrequente Spannung, so nimmt der kapazitive Widerstand des RC-Gliedes sehr große Werte gegenüber dem parallel geschalteten Widerstand Re an. Man misst also praktisch nur den ohmschen Widerstand Re der leitenden Flüssigkeit. Eine zuverlässige Bestimmung des $\varepsilon$ des entsprechenden Stoffes ist bei niedrigen Frequenzen also nicht mehr möglich. Dazu kommen noch Polarisationseffekte mit steigender Anzahl der Konzentration von Ionen im Lösungsmittel, die ein sehr komplexes Verhalten dieser Anordnung bei tiefen Frequenzen auslösen. Für eine Vielzahl entsprechender Stoffe ist jedoch gerade das Verhalten der Moleküle nur bei tiefen Frequenzen aussagekräftig.

Die nachfolgenden Beispiele sollen dies verdeutlichen. Hierbei geht es um die Realisierung der Messungen von

- Geleigenschaften und -entstehung, auch in wässrigen Lösungen
- Verteilung von Struktureinheiten und assoziierten Lösungsmittelkomplexen
- Entwicklung komplex zusammengesetzter Emulgator- bzw. Grenzflächenschichten
- Struktur von Wasserclustern bzw. hydratisierten Einheiten über der Frequenz
- Verhalten von Flüssigkeiten biologischer Systeme
- Populationen und absterbenden Populationen in Lösungen
- Mikrofilmen auf Leitern
- Restverunreinigungen und Biofilmen auf Anlagenkomponenten wie z.B. Edelstahlrohre oder Dichtungsgrenzflächen
- festen Dielektrika, die von flüssigen Stoffen umgeben sind
- Qualitätseigenschaften von Elektrolytmatrices
- Entwicklung organischer Solarzellen

Während in diesen Bereichen der Messtechnik optische Methoden nur indirekte Daten liefern können, machen dielektrische Eigenschaften gerade bei tiefen Frequenzen direkte Aussagen über Effekte im Mikro- und Nanobereich. Deshalb sind für Stoffe und Materialien im sog. Life-Science-Bereich, also dem Gesundheits-, Lebensmittel- und pharmazeutischen Bereich, dielektrische Messungen bei tiefen Frequenzen gefordert und stark gefragt. Aber auch für andere Industrien, zum Beispiel in der Chemie und Petrochemie, sind solche Messungen von großem Interesse.

Es stellt sich daher die Aufgabe, ein Messverfahren sowie eine Messschaltung und Messeinrichtung bereitzustellen, die eine zuverlässige Bestimmung der dielektrischen Eigenschaften von leitfähigen Stoffen bei Messung mit einer niederfrequenten Spannung ermöglichen.

Da es keine allgemein gültige Definition zur Größe des Parallelwiderstandes gibt, soll für diese Anmeldung folgende Einteilung gelten:

R sehr groß: 1M Ohm und größer
R groß: 100 k Ohm bis 1 M Ohm
R mittelgroß: 10 k Ohm bis 100 k Ohm
R mittel: 1 k Ohm bis 10 k Ohm
R klein: 100 Ohm bis 1 k Ohm
R sehr klein: 1 Ohm bis 100 Ohm

Im UK-Patent GB 2 447 477 A wird ein Messverfahren beschrieben, das durch Kompensation des großen Stromes durch den niedrigen Parallelwiderstand eine effektivere Messung der dielektrischen Werte einer Probe mit hoher Leitfähigkeit erreichen will. Hierzu ist anzumerken:

- Es ist kein generelles Messverfahren, da für Proben, bei denen keine Vorinformation über die dielektrischen Eigenschaften bekannt sind, diese Messmethode nicht allgemein einsetzbar ist.
- Es ist ein sehr aufwendiges System und benötigt eine spezielle Software zur Einstellung der Kompensationsparameter, welche die o.g. Vorinformationen benötigen.
- Bei diesem Messverfahren ist nicht klar, ob alle Erkenntnisse aus [Lit.4] berücksichtigt sind.
- Auch ist es bei diesem Messverfahren nicht möglich, die Leitungsverluste von den frequenzabhängigen Verlusten, die durch Reibung der Dipole im Dielektrikum entstehen, zu trennen.
- Auch ist es bei diesem Messverfahren nicht möglich, Aussagen über die Beweglichkeit der Ionen zu machen.

Ausgehend von diesem Stand der Technik stellt sich hier das Problem, ein Messverfahren sowie eine Messschaltung und Messeinrichung bei einer Messspannung im Bereich tiefer Frequenzen bereitzustellen, die die oben aufgeführten Einschränkungen nicht aufweisen und die Messung der bisher in diesem Bereich nicht zugänglichen Parameter ermöglichen.

Die genannten Aufgaben werden erfindungsgemäß gelöst durch ein Messverfahren gemäß Anspruch 1 und eine Messvorrichtung nach Anspruch 10. Weitere vorteilhafte Ausgestaltungen der Erfindung sind in den abhängigen Ansprüchen 2 - 9 und 11 - 15 definiert.

Unter niedrigen Frequenzen wird für die vorliegende Anmeldung verstanden, dass die Frequenz < 50 kHz ist, insbesondere < 10 kHz und besonders bevorzugt < 1 kHz. Das erfindungsgemäße Verfahren eignet sich aber auch für Frequenzen > 50 kHz.

Übersicht der Figuren:

Fig. 1a    allgemeines Ersatzschaltbild (ESB) der Messzelle

Fig. 1b    paralleles Ersatzschaltbild (ESBp) der Messzelle

Fig. 1c    Vorwiderstand und serielles Ersatzschaltbild (ESBs)

Fig. 1d    Zeigerdiagramm zum seriellen Ersatzschaltbild (ESBs)

Fig. 1e    Gleichspannungsmessung

Fig. 1f    Wechselspannungsmessung

Fig. 2a1    Zeigerdiagramm zum parallelen Ersatzschaltbild (ESBp) mit Hilfswiderstand

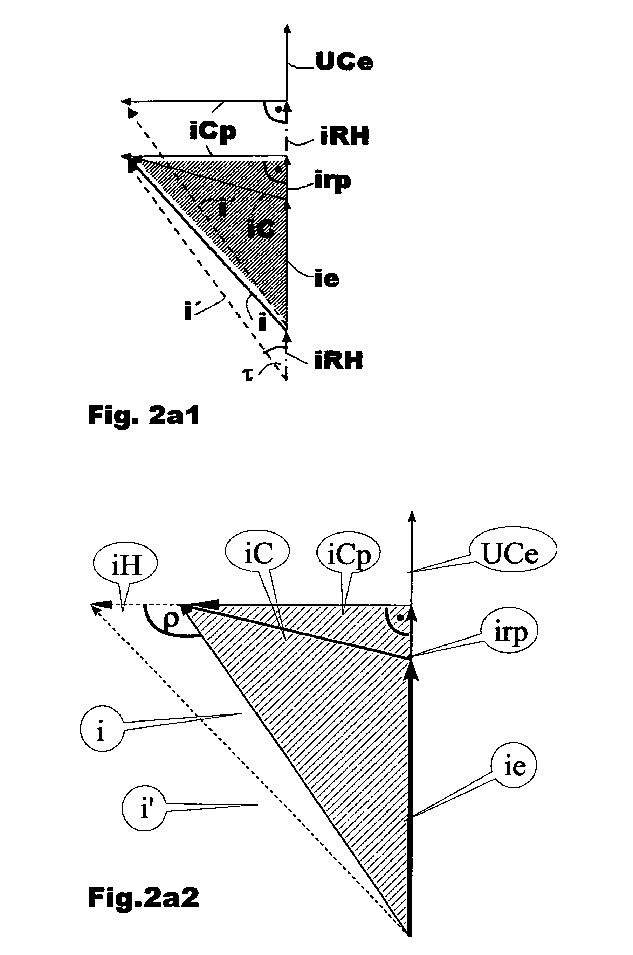

Fig. 2a2    Zeigerdiagramm zum parallelen Ersatzschaltbild (ESBp) mit Hilfskapazität

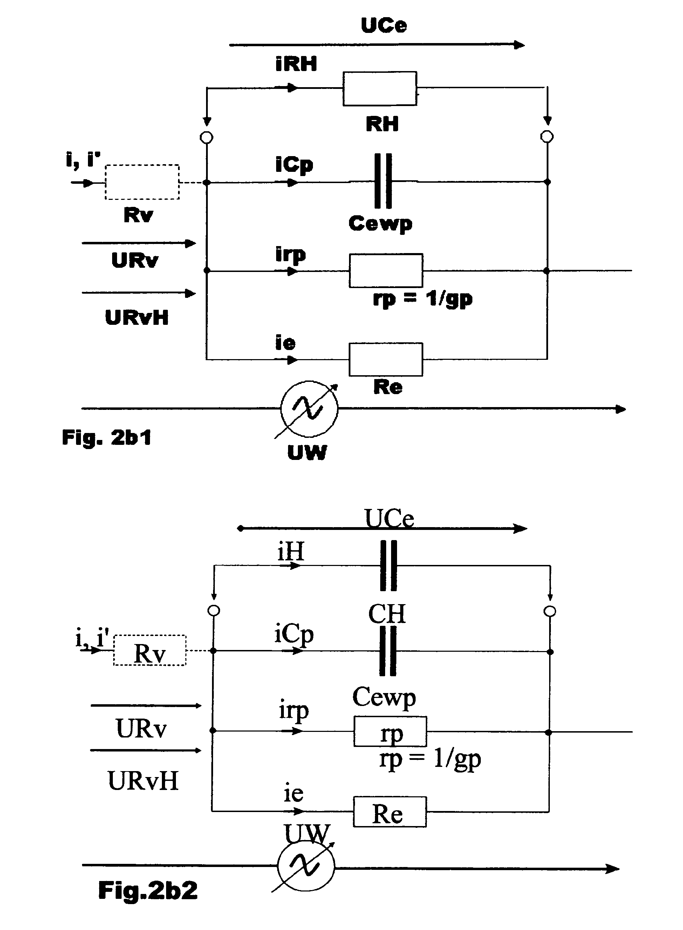

Fig. 2b1    Messung mit Hilfswiderstand (RH) und parallelem Ersatzschaltbild (ESBp)

Fig. 2b2    Messung mit Hilfskapazität (CH) und parallelem Ersatzschaltbild (ESBp)

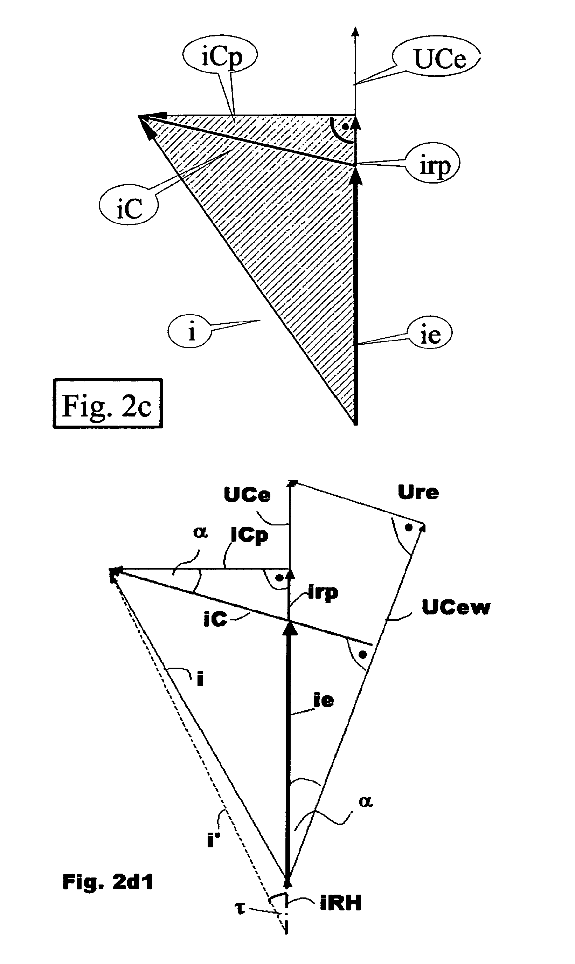

Fig. 2c    Zeigerdiagramm zum parallelen Ersatzschaltbild (ESBp) ohne Hilfsgrößen

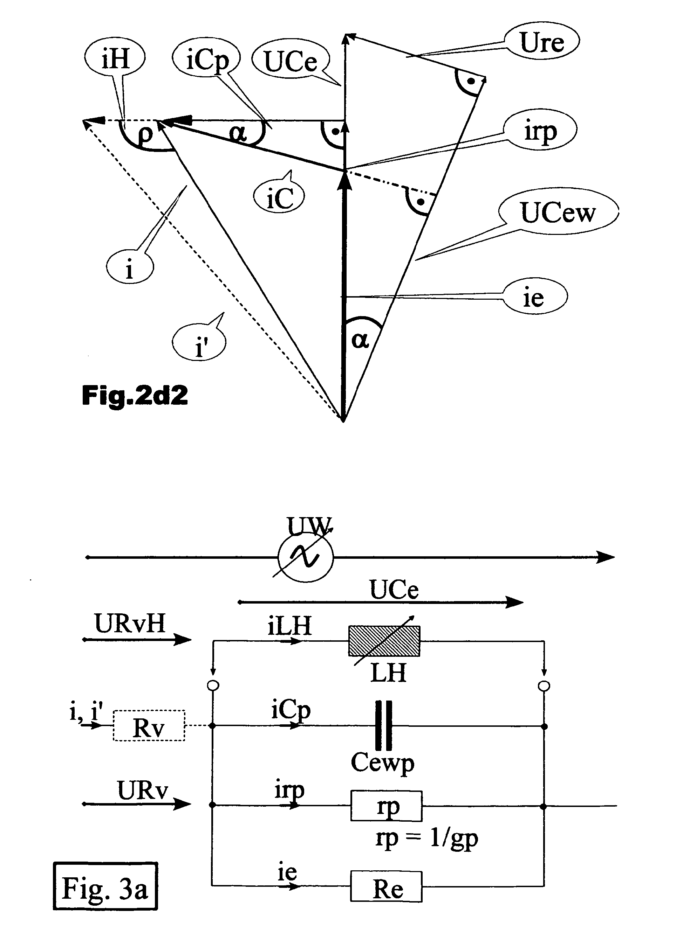

Fig. 2d1    erweitertes Zeigerdiagramm (Hilfswiderstand), in dem auch die Spannungen des ESBs ersichtlich sind

Fig. 2d2    erweitertes Zeigerdiagramm (Hilfskapazität), in dem auch die Spannungen des ESBs ersichtlich sind

Fig. 3a    Messung mit Hilfsinduktivität und parallelem Ersatzschaltbild (ESBp)

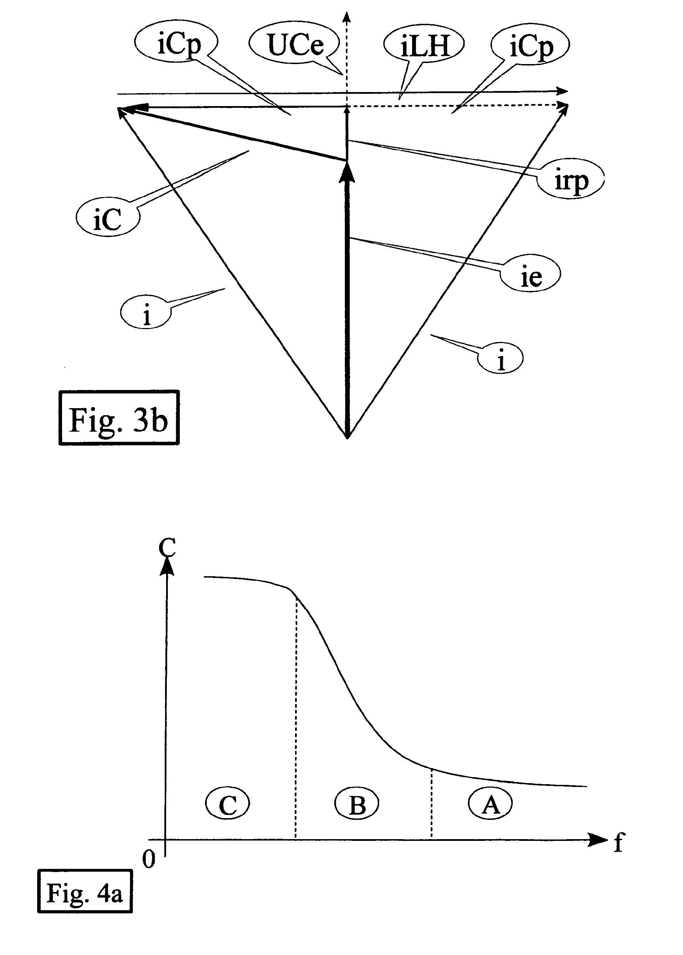

Fig. 3b    Zeigerdiagramm zum parallelen Ersatzschaltbild (ESBp) mit Hilfsinduktivität

Fig. 4a    Abhängigkeit der Kapazität C als Funktion der Frequenz bei ionenhaltigen Stoffen

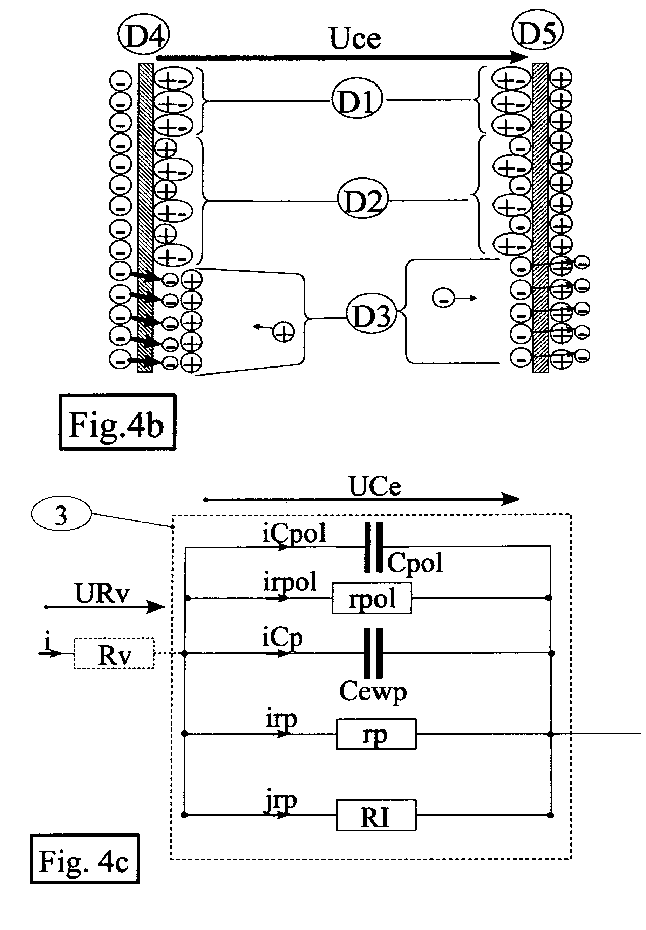

Fig. 4b    Darstellung der Vorgänge im Dielektrikum bei auftretender Raumladung

Fig. 4c    paralleles Ersatzschaltbild der Messzelle bei auftretender Raumladung

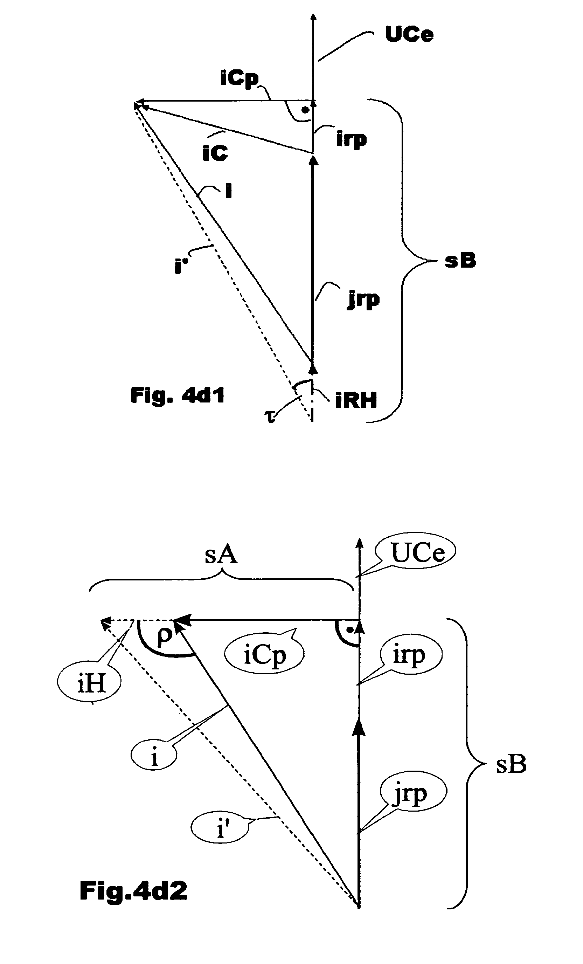

Fig. 4d1    Zeigerdiagramm mit Gesamtverluststrom sB auf der Grundlage vom ESBp bei ionenhaltigen Stoffen ohne Raumladungseffekt bei Messung mit Hilfswiderstand

Fig. 4d2    Zeigerdiagramm mit Gesamtverluststrom sB auf der Grundlage vom ESBp bei ionenhaltigen Stoffen ohne Raumladungseffekt bei Messung mit Hilfskapazität

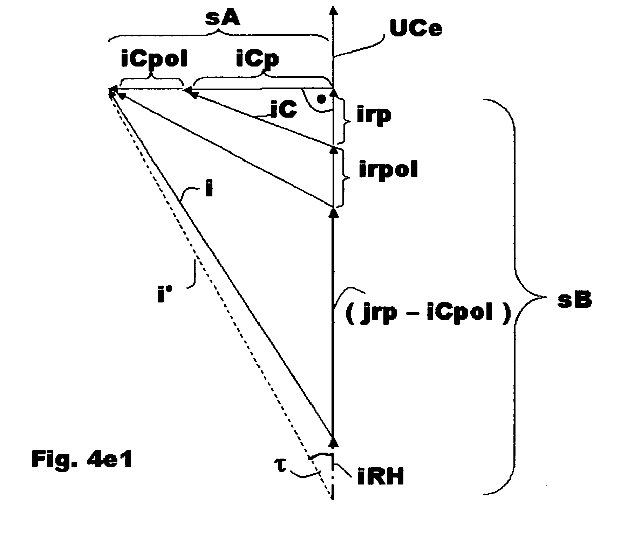

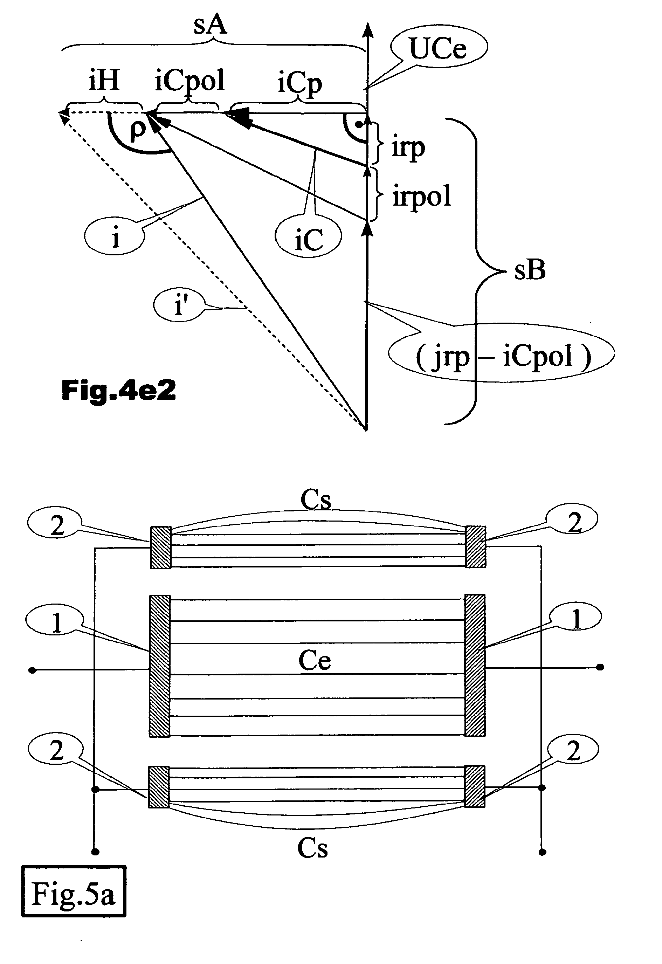

Fig. 4e1    Zeigerdiagramm mit gesamtem kapazitivem Strom sA und gesamtem Verluststrom sB auf der Grundlage von ESBp bei ionenhaltigen Stoffen mit Raumladungseffekt bei Messung mit Hilfswiderstand

Fig. 4e2    Zeigerdiagramm mit gesamtem kapazitivem Strom sA und gesamtem Verluststrom sB auf der Grundlage von ESBp bei ionenhaltigen Stoffen mit Raumladungseffekt bei Messung mit Hilfskapazität

Fig. 5a    Messzelle (1) mit Messelektroden und Schutzringelektroden

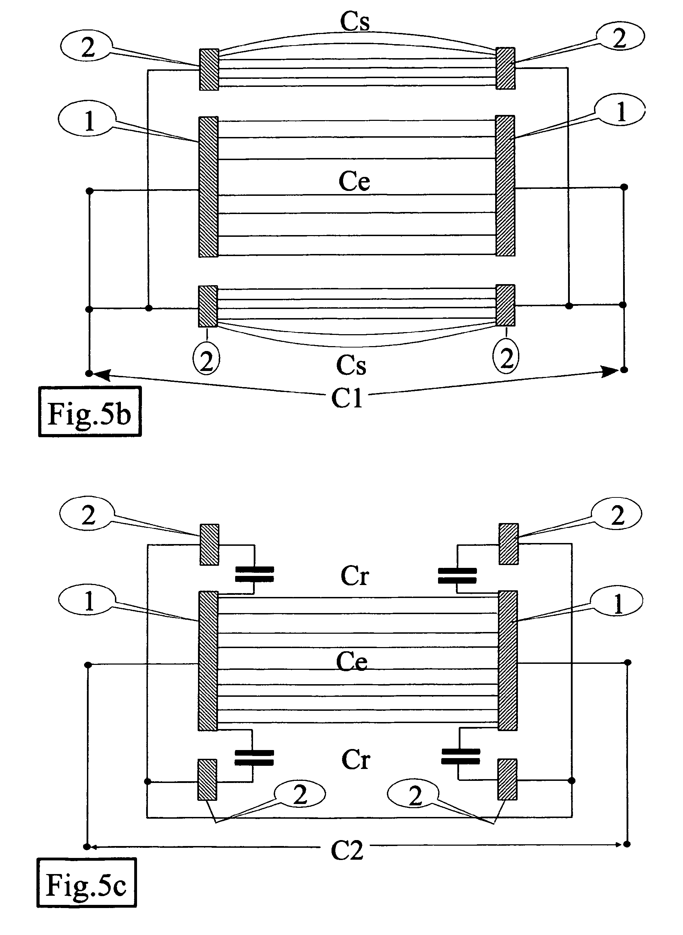

Fig. 5b    Messung von C1

Fig. 5c    Messung von C2

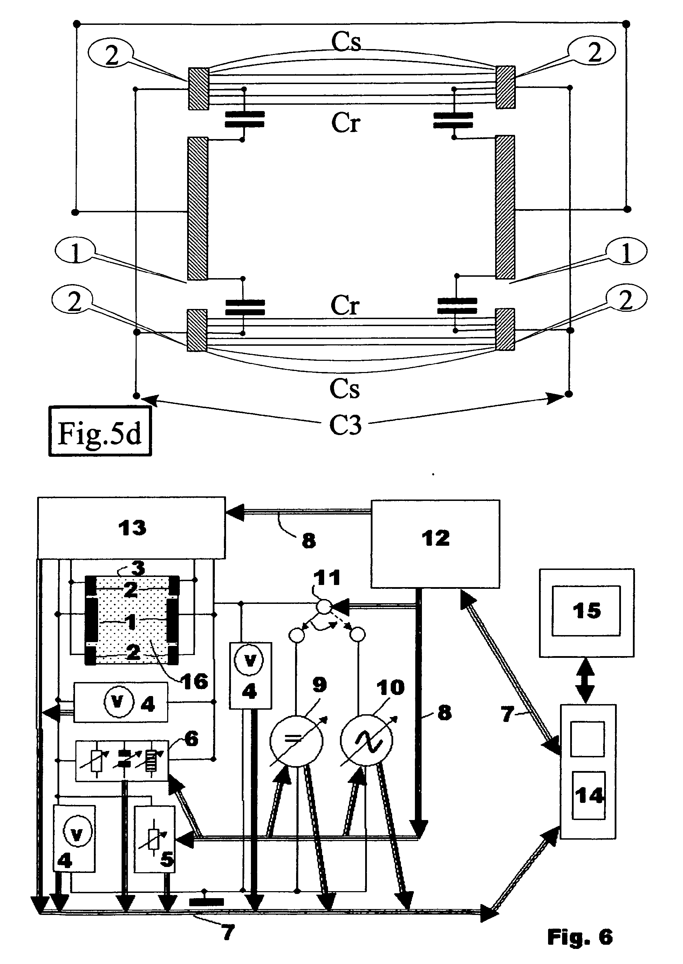

Fig. 5d    Messung von C3

Fig. 6    Schaltung und gerätemäßiger Aufbau der Messeinrichtung

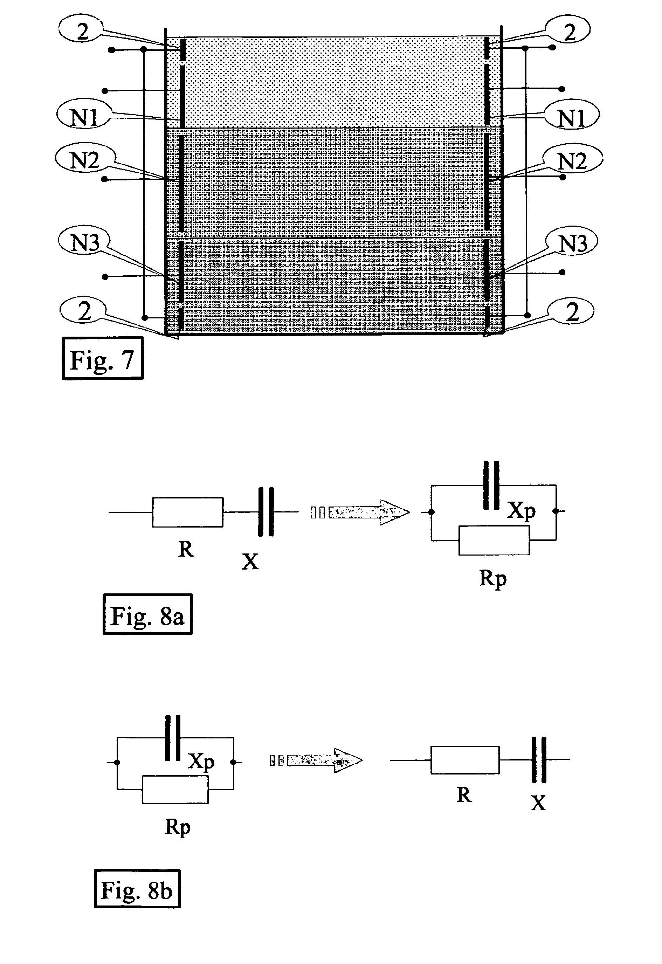

Fig. 7    Messzelle mit in der Höhe geteilten Elektroden

Fig. 8a    allgemein Umwandlung einer Serienschaltung in eine äquivalente Parallelschaltung

Fig. 8b    allgemein Umwandlung einer Parallelschaltung in eine äquivalente Serienschaltung

Die Erfindung wird nachfolgend näher erläutert. Die Erfindung ist dabei nicht auf die dargestellten Ausführungsbeispiele beschränkt. Abwandlungen im Rahmen des durch die Ansprüche definierten Schutzbereiches sind möglich.

Die Grundidee der vorliegenden Erfindung ist, mit ZEIGERDIAGRAMMEN komplexer Größen zu arbeiten, die aus geeigneten Ersatzschaltbildern der Messzelle abgeleitet werden. Die in den Zeigerdiagrammen verwendeten Wechselspannungs- und Wechselstromgrößen sind Effektivwerte. Die Ersatzschaltbilder werden durch geeignete Beschaltung der Messzelle und Rechenmaßnahmen so modifiziert, dass die gesuchten Eigenschaften des Dielektrikums bestimmt werden können.

Für alle in dieser Anmeldung vorgeschlagenen Verfahren gilt, dass bei einem Vergleich von Gleichspannung und Wechselspannungen für die Wechselspannung der Effektivwert gilt. Dies ist insbesondere der Fall bei den Verfahrensschritten, wo die Wechselspannung UW so eingeregelt wird, dass ihr Effektivwert einer vorgegebenen Gleichspannung über den Elektroden der Messzelle entsprechen soll.

Zum Verständnis der Erfindung werden in den folgenden Absätzen zunächst die benötigten Ersatzschaltbilder definiert:

Eine Messzelle zur Ermittlung der Dielektrizitätskonstante ist beispielsweise in der DE 20 2004 006 926 U1 offenbart. Bei dieser Messzelle befindet sich das leitende Medium, dessen Dielektrizitätskonstante gemessen werden soll, zwischen zwei Elektroden (1). Für Messzellen dieser Art kann man allgemein für die Messzelle (3) ein Ersatzschaltbild (ESB) gemäß Fig. 1a angeben. Dabei ist C die auftretende Kapazität, r ihr Reihenverlustwiderstand (Verluste durch die Reibung der Dipole im Dielektrikum) und Re der Verlustwiderstand, der die Verluste bei Leitung des Dielektrikums darstellt. Dieses Ersatzschaltbild ist jedoch für die Messbarkeit und die Betrachtung im Zeigerdiagramm nicht gut geeignet.

Für das erfindungsgemäße Verfahren werden deshalb zwei weitere äquivalente Ersatzschaltbilder für die Messzelle definiert, nämlich das parallele Ersatzschaltbild (ESBp) und das serielle Ersatzschaltbild (ESBs).
Fig.1b zeigt das parallele Ersatzschaltbild (ESBp) der Messzelle (3). Dabei ist Cewp die ermittelte Parallelkapazität, rp der ermittelte Verlustwiderstand der frequenzabhängigen Reibungsverluste der Dipole, und Re stellt die Verluste durch die Leitung des Dielektrikums dar. Dieses parallele Ersatzschaltbild (ESBp) erhält man durch Umwandlung der Serienschaltung von r und C aus Fig.1a in die Parallelschaltung aus Cewp und rp mit den Formeln [Lit. 5, S. 83, Formel 196 und 197, siehe Anhang]. Es dürfen hier keine Näherungen verwendet werden, wie es bei der Bestimmung des Verlustwinkels Tangens delta (tan $\delta$) bei Kondensatoren mit kleinen Verlusten üblich ist.

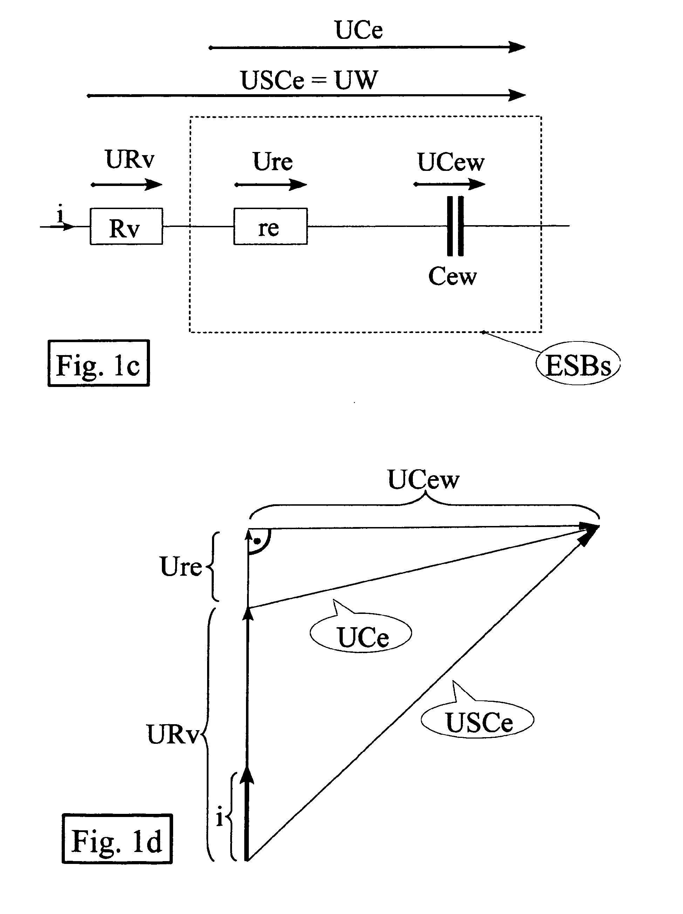

Das serielle Ersatzschaltbild (ESBs) der Messzelle (3) ist in Fig.1c dargestellt. Dabei ist Cew die ermittelte Reihenkapazität und re der ermittelte gesamte Verlustwiderstand der Reihenschaltung. Dieses serielle Ersatzschaltbild (ESBs) erhält man durch Umwandlung des parallelen Ersatzschaltbildes (ESBp) aus Fig.1b mit den Formeln [Lit.5, S. 85, Formelpaar 203, siehe Anhang], auch hier darf keine Näherung angewendet werden. Bei Betrachtung der Fig.1c wird klar, dass in diesem seriellen Ersatzschaltbild (ESBs) alle für das zugehörige Zeigerdiagramm (siehe Fig.1d) notwendigen Größen messbar sind.

Auch ist es nötig, die gestellte Aufgabe für die erfinderische Lösung auf Grund der großen Komplexität bei Ionenleitung in zwei Teile zu untergliedern:

Teil 1: dielektrische Eigenschaften bei leitendem Dielektrikum mit keinen oder vernachlässigbaren Raumladungseffekten;
Teil 2: dielektrische Eigenschaften bei leitendem Dielektrikum mit signifikanten Raumladungseffekten.

Zu Teil 1: Erfindungsgemäßes Messverfahren zur Messung der dielektrischen Eigenschaften bei leitendem Dielektrikum mit keinen bzw. vernachlässigbaren Raumladungseffekten

1.Ausführungsbeispiel: Messverfahren unter Anwendung des seriellen Ersatzschaltbildes

Grundlage dieses Messverfahrens ist die Betrachtung der Messzelle (3) im seriellen Ersatzschaltbild (ESBs), wie in Fig.1c dargestellt. Mit der Ergänzung eines Vorwiderstandes Rv (zur Bestimmung des Stromes i) werden nun die drei Wechselspannungen URv, UCe und USCe bei der ausgewählten Messfrequenz an der Messzelle gemessen. Mittels dieser drei Spannungen lassen sich dann aus dem Zeigerdiagramm nach Fig.1d mit Kenntnis von Rv (wählbar) die Werte für die Reihenkapazität Cew und den Reihenverlustwiderstand re bestimmen. Dieser Reihenverlustwiderstand re beinhaltet alle Verlustgrößen des parallelen Ersatzschaltbildes (ESBp) aus Fig. 1b. Die Bestimmung kann graphisch oder, aus Gründen der Genauigkeit, durch trigonometrische Rechnung erfolgen.

Mit Kenntnis von Cew und re hat man dann die Möglichkeit, diese Werte in ein paralleles Ersatzschaltbild zurück umzuwandeln. Die Umwandlung erfolgt wie bereits in [Lit.5, S.83, Formel 196, 197, siehe Anhang] angegeben. Die Umwandlung wieder zurück in ein paralleles Ersatzschaltbild ist notwendig, da das dann erhaltene Ersatzschaltbild mit der Geometrie der Messzelle korrespondiert und damit die $\varepsilon$-Bestimmung aus der Elektrodenfläche und dem Elektrodenabstand möglich wird. Das heißt, wir haben hier einen Plattenkondensator mit parallelen Elektroden und der gesamte Verlustwiderstand Rges ist parallel geschaltet.

Die Erfindung geht dabei von der Erkenntnis aus, dass der Gesamtverlustwiderstand Rges = 1/Ges sowohl die Verluste der Leitung durch das Dielektrikum als auch die frequenzabhängigen Verluste der Dipolbewegung beinhaltet. Um diese rechnerisch zu trennen, muss man noch eine Gleichstrommessung durchführen. Damit erhält man den Verlustleitwert Ge der Leitung durch das Dielektrikum. Von dem Gesamtverlustleitwert Ges ist dann dieser Verlustleitwert Ge abzuziehen. Als Ergebnis erhält man den frequenzabhängigen Verlustleitwert, der die komplexe Dielektrizitätskonstante $\varepsilon^*$ mitbestimmt.

Erfindungsgemäß werden also folgende Verfahrensschritte zur Bestimmung von $\varepsilon^*$ durchgeführt:

1. Über einen Vorwiderstand Rv wird eine variable Gleichspannungsquelle UG an die Klemmen bzw. die Elektroden (1) der Messzelle (3) angeschlossen.

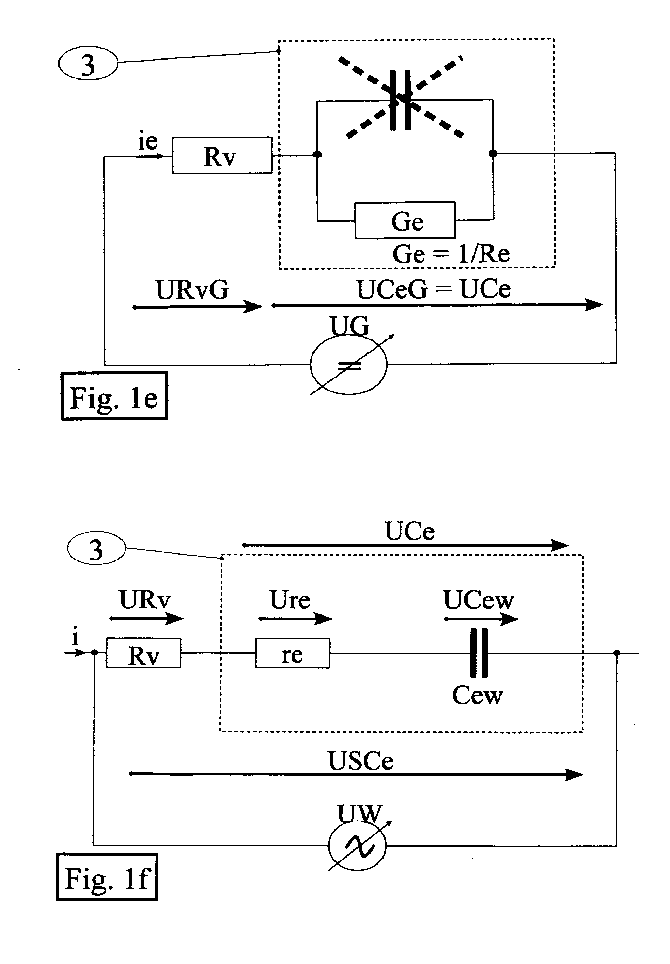

2. Einregeln von UG, so dass ein vorgegebenes UCe = UCeG über den Elektroden der Messzelle (3) erreicht wird (Fig. 1e).

3. Dann Messung der sich dazu einstellenden Spannung URvG über dem Vorwiderstand Rv (Fig.1e).

4. Bestimmung des Stromes ie durch den Vorwiderstand und die Messzelle aus der Beziehung: ie = URvG/Rv.

5. Bestimmung von Re aus UCe / ie.

Damit kennt man den Verlustleitwert Ge = 1/Re für das Ersatzschaltbild Fig.1e.
Der Verlustleitwert kann auch aus einer getrennten Leitwertmessung (mit Gleichspannung) der Probe und mittels der geometrischen Daten der Messzelle bestimmt werden.

6. Anschluss einer variablen Wechselspannungsquelle UW über den Vorwiderstand Rv an die Messzelle (3) (Fig.1f).

7. Einregeln von UW, so dass die vorgegebene Spannung UCe (gleiche Spannung wie in Schritt 2) über den Elektroden der Messzelle (3) erreicht wird.

8. Dann Messung der sich dazu einstellenden Spannung URv über dem Vorwiderstand Rv.

9. Messen der Spannung UW = USCe.

10. Bestimmung von Cew und re mittels dem Zeigerdiagramm Fig.1d aus den Spannungen USCe, UCe, URv und Ure mit dem Strom i = URv/Rv.

11. Umrechnung der Reihenschaltung re - Cew in die äquivalente Parallelschaltung gemäß [Lit.5, S.83, Formeln 196,197, siehe Anhang], wobei man Cewp und den parallelen Gesamtverlustleitwert Ges erhält.

12. Von dem parallelen Gesamtverlustleitwert Ges ist dann der Verlustleitwert Ge abzuziehen.

13. Als Ergebnis erhält man den frequenzabhängigen Verlustleitwert gp = 1/rp (Fig1b), der den Imaginärteil $\varepsilon''$ des komplexen $\varepsilon^*$ mitbestimmt.

14. Aus Cewp und der Geometrie der Messzelle wird $\varepsilon$ bestimmt.

15. Berechnet man aus Cewp und rp mit den Formeln [Lit. 5, S. 85, siehe Anhang] die äquivalente Reihenschaltung aus r und C, so sind alle Größen der Messzelle (Fig.1a) bestimmt.

16. Bestimmt man den tan $\delta$ = (r · C · $\omega$), ($\omega$ ist die Kreisfrequenz der Messspannung), so gilt für das komplexe $\varepsilon^*$:

$$\varepsilon^* = \varepsilon' - j\ \varepsilon'';$$

da tan $\delta$ gleich $\varepsilon''/\varepsilon'$:

$$\varepsilon' = \varepsilon;$$

und damit:

$$\varepsilon'' = \tan \delta \cdot \varepsilon'.$$

Durch diese Verfahrensschritte sind die dielektrischen Eigenschaften leitender Stoffe bestimmt. Vorteilhaft ist also, dass auf einfache Weise durch nur vier Spannungsmessungen die gesuchten Größen des unbekannten Dielektrikums auch bei niedrigen Frequenzen bestimmt werden können.

2.Ausführungsbeispiel: Messverfahren unter Anwendung des parallelen Ersatzschaltbildes mit Hilfswiderstand (RH) (HILFSGRÖSSENMETHODE)

Die Messung nach dem ersten Ausführungsbeispiel gestaltet sich jedoch schwierig, wenn der Gesamtverlustwiderstand Werte < 1kOhm erreicht. In diesem Fall muss der Strom durch die Messzelle entsprechend ansteigen, um verwertbare Größen für die Spannung UCe in Relation zu den anderen Messspannungen zu erhalten. Diese Relation ist aber notwendig, um mit genügender Genauigkeit die gesuchten Größen aus dem Zeigerdiagramm Fig. 1d zu ermitteln. Auch kann ein zu hoher Strom gegebenenfalls das Dielektrikum so verändern, dass die Messwerte nicht mehr den Betriebsbedingungen des Dielektrikums entsprechen.

Ergibt also die Gleichstrommessung einen kleinen Re, ist es erfindungsgemäß vorteilhaft, das Messverfahren unter Anwendung des parallelen Ersatzschaltbildes (ESBp) aus Fig.1b durchzuführen. Hier ergibt sich die Bestimmung der gesuchten Werte mittels Zeigerdiagramm, wenn man das Zeigerdiagramm Fig. 2a1, das die Ströme aus Fig. 1b darstellt, verwendet. Die Ströme iCp und irp sind der Messung nicht zugänglich. Lediglich die Ströme i und ie sind messbar. Wird nun ein bekannter Hilfswiderstand RH parallel zum Ersatzschaltbild Fig. 1b angefügt, wie in Fig. 2b1 gezeigt, erhält man eine Ergänzung mit dem Strom iRH (strichpunktiert) im Zeigerdiagramm Fig.2a1. Bei gleichem Wert von UCe kann man entsprechend die Ströme i und i' (gestrichelt mit angeschaltetem Hilfswiderstand RH) messen.

Der Strom iRH durch den Hilfswiderstand RH kann aus der Spannung UCe an der parallelen Ersatzschaltung und dem bekannten Hilfswiderstand RH bei der entsprechenden Frequenz berechnet werden. Diese Zuschaltung des Hilfswiderstandes RH, sie ist ebenfalls in Fig.2b1 dargestellt, bewirkt den Hilfsstrom iRH (strichpunktiert in Fig. 2a1). Da sich an der Darstellung im Zeigerdiagramm keine Änderung ergibt, wenn man Zeigergrößen in ihrer Wirkungslinie verschiebt, wird nun der Strom iRH (strichpunktiert) unten angefügt, (siehe Fig. 2a1). Damit sind alle Strecken des Dreiecks (i, i', iRH) messtechnisch bestimmt. Mittels Cosinus-Satz ist der Winkel tau (τ) errechenbar. Zur Bestimmung der Ströme i und i' wird die Spannung URv ohne RH bzw. URvH mit RH am Vorwiderstand Rv gemessen.

Voraussetzung für die Berechnung der gesuchten Größen ist, dass sich bei diesen Messungen UCe und die Kreisfrequenz (ω) nicht ändern.

Dann wird über eine variable Generatorspannung UW die Spannung UCe nach der Zuschaltung des Hilfswiderstandes RH auf den gleichen Wert wie ohne RH gebracht. Bei dieser Einstellung verändern sich im Zeigerdiagramm (Fig. 2a1) die Ströme i und ie nicht gegenüber dem Zeigerdiagramm ohne Ergänzung durch RH. Dies wird durch die beiden gleichen Dreiecke (schraffiert in Fig. 2a1 und Fig. 2c) deutlich.

Man findet also im Zeigerdiagramm Fig. 2a1 das Dreieck gebildet aus den Seiten i, i' und iRH mit dem Winkel tau (τ) zwischen iRH und i'. Dieser Winkel ist nach dem Cosinus-Satz berechenbar.

Mit Kenntnis des Winkels tau(τ) und des eingezeichneten rechten Winkels im Dreieck i', iCp (irp+ie+iHR) lassen sich die unbekannten Stromgrößen iCp, irp und iC bestimmen. Der Strom ie wurde, wie bereits beschrieben, aus der Gleichspannungsmessung bei UCe als Spannung an der Messzelle ermittelt.

Nun können die dielektrischen Eigenschaften bestimmt werden aus:

$$Cewp = iCp/(\omega * UCe);$$ mit ω = Kreisfrequenz der Messspannung

$$rp = UCe/irp;$$ rp = frequenzabhängiger Verlustwiderstand auf Grund der Reibung der Dipole des Dielektrikums

$$gp = 1/rp;$$ gp = frequenzabhängiger Verlustleitwert auf Grund der Reibung der Dipole des Dieektrikums

$$Re = UCe/ie;$$ Re = Leitungsverluste

$$Ge = 1/Re;$$ Ge = Verlustleitwert

Über das Zeigerdiagramm Fig. 2d1 findet man dann auch die Größen Ure und UCew, die im seriellen Ersatzschaltbild (ESBs) in Fig.1c dargestellt sind.

Erfindungsgemäß werden also im zweiten Ausführungsbeispiel an Stelle der Verfahrensschritte 10, 11 und 12 des ersten Ausführungsbeispiels die folgenden Schritte durchgeführt:

- Zuschalten eines Hilfswiderstandes (RH) parallel zu den mindestens zwei Elektroden
- Einregeln einer zweiten Wechselspannung (UW) durch die variable Spannungsquelle (UW), so dass sich jeweils der gleiche Spannungswert (UCe) über den mindestens zwei Elektroden ergibt, wie vorher beim Einregeln der Gleichspannung (UG) und der ersten Wechselspannung ohne Hilfswiderstand (RH), wobei die erste und die zweite Wechselspannung die gleiche Kreisfrequenz (ω) haben
- Bestimmung des zugehörigen Wechselstroms (i') aus der Spannung (URvH) über dem Vorwiderstand (Rv) und dem Wert des Vorwiderstands (Rv)
- Bestimmung des Stromes (iRH) durch den Hilfswiderstand (RH) aus der Spannung (UCe) zwischen der ersten und der zweiten Elektrode und dem Wert des Hilfswiderstandes (RH)
- Ermittlung der unbekannten Strom- und Spannungsgrößen aus dem Zeigerdiagramm auf Grundlage eines parallelen Ersatzschaltbildes (ESBp)
- Bestimmung der parallelen Gesamtkapazität (Cewp) aus dem Strom (iCp) durch die parallele Gesamtkapazität und der Spannung (UCe) zwischen der ersten und der zweiten Elektrode.

3. Ausführungsbeispiel: Messverfahren unter Anwendung des parallelen Ersatzschaltbildes mit Hilfskapazität (CH) (Hilfsgrößenmethode)

Wird nun zusätzlich eine verlustarme, bekannte Hilfskapazität CH parallel zum Ersatzschaltbild Fig.1b angefügt, wie in Fig.2b2 gezeigt, erhält man eine Ergänzung mit Strom iH im Zeigerdiagramm Fig.2a2. Bei gleichem Wert von UCe kann man entsprechend die Ströme i und i' (gestrichelt = mit angeschalteter Hilfskapazität) messen. Der Strom iH durch die Hilfskapazität CH kann aus der Spannung UCe an der Ersatzschaltung und der bekannten Hilfskapazität CH bei der entsprechenden Frequenz berechnet werden.

Diese Zuschaltung der Hilfskapazität CH, sie ist ebenfalls in Fig. 2b2 dargestellt, bewirkt den Hilfsstrom iH (gestrichelt) und es ergibt sich nun der Winkel rho(p) (Fig. 2a2). Damit wird die Berechnung des Dreiecks (i, i', iH) trigonometrisch möglich. Zur Bestimmung der Ströme i und i' wird die Spannung URv ohne CH bzw. URvH mit CH am Vorwiderstand Rv gemessen. Voraussetzung für die Berechnung der gesuchten Größen ist, dass sich bei diesen Messungen UCe und die Kreisfrequenz ($\omega$) nicht ändern.

Deshalb wird über eine variable Generatorspannung UW die Spannung UCe nach Zuschaltung der Hilfskapazität CH auf den gleichen Wert wie ohne CH gebracht. Bei dieser Einstellung verändern sich im Zeigerdiagramm (Fig. 2a2) die Ströme i und ie nicht gegenüber dem Zeigerdiagramm ohne Ergänzung durch CH. Dies wird durch die beiden gleichen Dreiecke (schraffiert) in Fig. 2a2 und Fig. 2c deutlich.

Man findet also im Zeigerdiagramm Fig. 2a2 das Dreieck gebildet aus den Seiten i, i' und iH, mit denen man den Winkel rho(p) zwischen iH und i nach dem Cosinus-Satz berechnen kann. Ebenso sind die beiden weiteren Winkel des Dreiecks i, i' und iH nun über trigonometrische Beziehungen bestimmbar.

Mit Kenntnis dieser beiden Winkel und des eingezeichneten rechten Winkels lassen sich die unbekannten Stromgrößen iCp, irp und iC bestimmen. Der Strom ie wurde, wie bereits beschrieben, aus der Gleichspannungsmessung bei UCe als Spannung an der Messzelle ermittelt.

Nun können die dielektrischen Eigenschaften bestimmt werden aus:

$$Cewp = iCp/(\omega*UCe);$$  mit $\omega$ = Kreisfrequenz der Messspannung

$$rp = UCe/irp;$$  rp = frequenzabhängiger Verlustwiderstand auf Grund der Reibung der Dipole des Dielektrikums

$$gp = 1/rp;$$  gp = frequenzabhängiger Verlustleitwert auf Grund der Reibung der Dipole des Dielektrikums

$$Re = UCe/ie;$$  Re = Leitungsverluste

$$Ge = 1/Re;$$  Ge = Verlustleitwert

Über das Zeigerdiagramm Fig. 2d2 findet man dann auch die Größen Ure und UCew, die im seriellen Ersatzschaltbild (ESBs) in Fig.1c dargestellt sind.

Erfindungsgemäß werden also im dritten Ausführungsbeispiel an Stelle der Verfahrensschritte 10, 11 und 12 des ersten Ausführungsbeispiels die folgenden Schritte durchgeführt:

- Zuschalten einer Hilfskapazität (CH) parallel zu den mindestens zwei Elektroden
- Einregeln einer zweiten Wechselspannung (UW) durch die variable Spannungsquelle (UW), so dass sich jeweils der gleiche Spannungswert (UCe) über den mindestens zwei Elektroden ergibt, wie vorher beim Einregeln der Gleichspannung (UG) und der ersten Wechselspannung ohne Hilfskapazität, wobei die erste und die zweite Wechselspannung die gleiche Kreisfrequenz ($\omega$) haben
- Bestimmung des zugehörigen Wechselstroms (i') aus der Spannung (URvH) über dem Vorwiderstand (Rv) und dem Wert des Vorwiderstands (Rv)
- Bestimmung des Stromes (iH) durch die Hilfskapazität (CH) aus der Spannung (UCe) zwischen der ersten und der zweiten Elektrode und dem Wert der Hilfskapazität (CH)
- Ermittlung der unbekannten Strom- und Spannungsgrößen aus dem Zeigerdiagramm auf Grundlage eines parallelen Ersatzschaltbildes (ESBp)
- Bestimmung der parallelen Gesamtkapazität (Cewp) aus dem Strom (iCp) durch die parallele Gesamtkapazität und der Spannung (UCe) zwischen der ersten und der zweiten Elektrode

- Bestimmung des frequenzabhängigen Verlustleitwerts (gp) aus dem Strom (irp) durch den Verlustwiderstand (rp) und der Spannung (UCe) zwischen der ersten und der zweiten Elektrode.

4. Ausführungsbeispiel: Messverfahren unter Anwendung des parallelen Ersatzschaltbildes mit Hilfsinduktivität (LH) (HILFSGRÖSSENMETHODE)

Fig.3a zeigt eine Alternative, bei der anstelle der Hilfskapazität für die Bestimmung des unbekannten Stromes iCp im Zeigerdiagramm eine Hilfsinduktivität verwendet wird. Schaltet man statt der Hilfskapazität CH eine variable Hilfsinduktivität LH parallel zur Messzelle (3) und vergrößert diese, so wird zuerst der unbekannte Strom iCp kompensiert, was an einem Minimum von i zu erkennen ist. Da dieses Minimum gegebenenfalls sehr flach ausfallen kann, ist es vorteilhaft, durch Erhöhen von LH zu einer Überkompensation fortzufahren, bis der ursprüngliche Betrag des Stromes i wie vor dem Zuschalten der Hilfsinduktivität LH wieder erreicht wird. Im Zeigerdiagramm Fig. 3b ist das sich ergebende gleichschenklige Dreieck zu ersehen, dessen Basis durch den Überkompensationsstrom iLH der Induktivität gegeben ist. Unter der Voraussetzung, dass UCe konstant gehalten wurde, lässt sich dieser Strom iLH aus dem Wert der Hilfsinduktivität LH, der Messfrequenz w und UCe berechnen. Es gilt gemäß Fig.3b dann für den unbekannten Strom:

$$iCp = \frac{1}{2} \, iLH.$$

Auch eine weitere Überkompensation über die Gleichheit des Stroms i aus Fig.3b hinaus ist möglich. Man erhält dann eine spiegelbildliche Darstellung der Fig. 2a2 und kann entsprechend über den Winkel rho ($\rho$) die gesuchten Größen bestimmen.

Erfindungsgemäß werden also im dritten Ausführungsbeispiel an Stelle der Verfahrensschritte 10, 11 und 12 des ersten Ausführungsbeispiels die folgenden Schritte durchgeführt:

- Zuschalten einer variablen Hilfsinduktivität (LH) parallel zu den mindestens zwei Elektroden
- Vergrößern der variablen Hilfsinduktivität (LH), und dabei Konstanthalten des Spannungswertes (UCe) über den mindestens zwei Elektroden durch Nachregeln der variablen Spannungsquelle (UW), wobei gleichzeitig der Betrag des Wechselstromes (i) durch die Messzelle gemessen wird, solange, bis der Betrag des Wechselstroms (i) ein Minimum durchlaufen und wieder den ursprünglichen Betrag (i) erreicht hat, den er vor dem Zuschalten und Vergrößern der variablen Hilfsinduktivität (LH) hatte, dann Ermittlung des zugehörigen Wertes der variablen Hilfsinduktivität (LH)
- Bestimmung des Stromes (iLH) durch die Hilfsinduktivität (LH) aus der Spannung zwischen der ersten und der zweiten Elektrode (UCe) und dem Wert der Hilfsinduktivität (LH)
- Ermitteln des Stromes iCP = ½ iLH
- Ermittlung der unbekannten Strom- und Spannungsgrößen aus dem Zeigerdiagramm auf Grundlage eines parallelen Ersatzschaltbildes (ESBp),
- Bestimmung der parallelen Gesamtkapazität (Cewp) aus dem Strom (iCp) durch die parallele Gesamtkapazität und der Spannung (UCe) zwischen der ersten und der zweiten Elektrode
- Bestimmung des frequenzabhängigen Verlustleitwerts (gp) aus dem Strom (irp) durch den Verlustwiderstand (rp) und der Spannung (UCe) zwischen der ersten und der zweiten Elektrode.

Wesentlicher Vorteil der Ausführungsbeispiele 2, 3 und 4 ist also, dass durch die Zuschaltung von den jeweiligen Hilfsgrößen (Hilfswiderstand, Hilfskapazität, Hilfsinduktivität) eine zuverlässige ε-Messung auch bei einem sehr kleinen Gesamtverlustwiderstand < 1 kOhm mit geringem Aufwand möglich ist. Die Ausführungsbeispiele 2, 3 und 4 bzw. die entsprechenden Verfahren gemäß der Ansprüche 2, 3 und 4 werden daher als HILFSGRÖSSENMETHODE bezeichnet.

Zur Steigerung der Messgenauigkeit ist es auch möglich, diese Hilfsgrössenmethode nacheinander für je eine der Hilfsgrößen (Hilfswiderstand, Hilfskapazität, Hilfsinduktivität) durchzuführen und die Messergebnisse zu mitteln.

Sind die Voraussetzungen für die verlustarmen Hilfsgrößen kapazitiver bzw. induktiver Art nicht gegeben, hat man ausserdem die Möglichkeit, nachdem man die Verlustwiderstände von Kapazität und Induktivität gemessen hat, diese in den entsprechenden Zeigerdiagrammen zu berücksichtigen. Auf diese Weise erhält man auch bei verlustbehafteten Hilfsgrößen ein korrektes Messergebnis.

Es besteht bei der Hilfsgrössenmethode auch die Möglichkeit, sich das messtechnisch aufwendigere Konstanthalten der Bezugsspannung UCe zu ersparen. Dazu kann man wie folgt vorgehen:

Messung bei fester Generatorspannung UW und der Spannung UCe1 ohne Hilfsgröße sowie der Spannung UCe2 mit angeschalteter Hilfsgröße:

In einem automatisierten Messverfahren ist es sicherlich messtechnisch aufwendiger, eine Spannung (UCe) mit der Generatorspannung UW für die Messung ohne und mit Hilfsgröße auf den gleichen Wert einzuregeln. Da jedoch die Zeigerdiagramme bei fester Generatorspannung UW mit und ohne Hilfsgrößen einander proportional sind, läßt sich sehr einfach ein Proportionalitätsfaktor errechnen, mit dem z.B. der Strom i (gemessen bei UCe1 ohne Hilfsgröße) so korrigiert werden kann, dass er dem Strom i' bei der dann an der Hilfsgröße gemessenen Spannung UCe2 entspricht. UCe2 ist hier Bezugsspannung.

Damit ist ein Weg gefunden, bei unveränderter Generatorspannung UW eine Messung ohne Hilfsgröße mit der Spannung UCe1 und eine Messung mit der Hilfsgröße mit der Spannung UCe2 durchzuführen und die für das Zeigerdiagramm benötigten Ströme i bzw. i' in einem Berechnungsprogramm so umzurechnen, als wäre die Spannung mit und ohne Hilfsgröße die gleiche. Dadurch ist die vorgegebene Voraussetzung für die Anwendbarkeit der Hilfsgrößenmethode erfüllt. Entsprechend muss aber auch der Strom der Leitungsverluste ie, der über die Gleichspannungsmessung bestimmt wurde, mit Hilfe des Verlustwiderstandes Re und der Bezugsspannung UCe2 für das Zeigerdiagramm errechnet werden.

Zu Teil 2: Erfindungsgemäßes Messverfahren zur Messung der dielektrischen Eigenschaften bei leitendem Dielektrikum mit signifikanten Raumladungseffekten

Die bisher aufgezeigten erfindungsgemäßen Verfahren zur Bestimmung der dielektrischen Eigenschaften leitender Dielektrika können bis in den Bereich mittlerer Widerstände R bei vorwiegend schlechter Isolation (bzw. guter Elektronenleitung) des Dielektrikums angewendet werden.

Das frequenzabhängige dielektrische Verhalten von ionenhalten Flüssigkeiten ist dagegen sehr komplex. Um es messtechnisch erfassen zu können, muss man es gemäß der auftretenden physikalischen Phänomene in entsprechende Bereiche einteilen.

Weiters kommt hinzu, dass die Ionenleitung sich wegen der an den Elektroden auftretenden Helmholtzschichten im Allgemeinen nicht aus einer einfachen Gleichstrommessung bestimmen läßt. Geht man von höheren Frequenzen aus zu niedrigeren, durchläuft man im Wesentlichen drei Bereiche. Wie scharf die Übergänge sind, hängt ab von den Proben, den beteiligten Ionen, ihrer Konzentration, der Temperatur des Lösungsmittels usw.

Das erste Gebiet (A) (siehe Fig. 4a), das man von höheren Frequenzen her kommend durchläuft, zeichnet sich physikalisch dadurch aus, dass die Verluste auf Grund der Ionenleitung gegenüber allen anderen Verlusten überwiegen, d.h. der Parallelwiderstand R ist sehr klein (es gilt die im einleitenden Teil dieser Anmeldung gemachte Definition zur Einteilung der Größe des Parallelwiderstands R).

Hinzu kommt bei noch niedrigeren Frequenzen das Auftreten einer zusätzlichen "Polarisationskapazität". Diese bewirkt ein Aufsplitten der Ionenleitung [Lit. 4], so dass sich der parallel geschaltete Widerstand (Ionenleitung) im Ersatzschaltbild sogar erhöht.

Fig. 4a zeigt schematisch drei Gebiete, die das dielektrische Verhalten ionenhaltiger Stoffe in Form der Kapazität C als Funktion der Frequenz f angeben:

Gebiet (A) ist der Abschnitt bei höheren Frequenzen, bei dem ein normales Verhalten von R und eine geometrisch bestimmbare Kapazität auftreten.

Gebiet (B) beschreibt den Raumladungsbereich: die Kapazitätswerte steigen enorm an durch die induzierte "Polarisationskapazität", während sich R vermindert.

Gebiet (C): Darin bestimmt die Relation zwischen Diffusionsstrom und Leitungsstrom die Verhältnisse. Es treten die aus der Gleichstrommessung bekannten Polarisationseffekte auf. In diesem Gebiet sind keine signifikanten Änderungen des kapazitiven Verhaltens zu erwarten. Das Verhalten des Ionenleitungsstromes wird im Wesentlichen durch die Helmholtzschichten an den Elektroden bestimmt.

Erfindungsgemäße Ableitung der Ersatzschaltbilder für dielektrische Messungen an ionenhaltigen Stoffen bei niedrigen Frequenzen zur Ermittlung der gesuchten Größen aus den entsprechenden Zeigerdiagrammen

Überträgt man die bekannten Darstellungen der Helmholtzschicht [Lit. 6, S. 40 und S. 42] für Gleichspannung auf eine Anwendung bei niedrigen Frequenzen im Raumladungsbereich, so erhält man Fig. 4b. Wie dort gezeigt, spielen sich im Dielektrikum folgende Vorgänge ab:

(D1): Die Dipole eines Lösungsmittels mit hohem Leitungswiderstand (z.B. destilliertes Wasser, d.h. ein reines Lösungsmittel mit niedriger Leitfähigkeit) lagern sich entsprechend ihrer Polung an die Elektroden an.

(D2): Die Ionen der Raumladung bilden in dem Lösungsmittel entsprechend der Polarität ihrer Ladung eine Ionenwolke an der jeweiligen Elektrode.

(D3): Ionen der Ionenleitung nehmen an den Elektroden entsprechende Ladungen auf oder geben sie dort ab.

(D4): Momentan negative Elektrode.

(D5): Momentan positive Elektrode.

Aus diesen Vorgängen lässt sich leicht das für die Berechnung der dielektrischen Eigenschaften mittels Zeigerdiagramm benötigte Ersatzschaltbild ableiten. Gemäß Fig. 4b lassen sich folgende Elemente für das Ersatzschaltbild Fig. 4c ermitteln:

- Auf Grund der dielektrischen Eigenschaften des Lösungsmittels erhält man die Kapazität Cewp mit einem parallelen Verlustwiderstand rp.
- Die Ionenwolke erhöht die elektrische Ladung QI an der Elektrode der Messzelle. Daraus resultiert eine Kapazitätserhöhung um die Größe der "Polarisationskapazität Cpol" (Cpol = QI / UCe). Ihr paralleler Verlustwiderstand rpol beinhaltet die Beweglichkeit der verschiedenen beteiligten Ioneneinheiten.
- Der parallel zu den Kapazitäten und Verlustwiderständen liegende Widerstand RI stellt die Ionenleitung dar.

Da allgemein, wie bereits angeführt, über eine Gleichstrommessung der Ionenleitungsstrom jrp für das Parallelersatzschaltbild nicht bestimmbar ist, geht man den folgenden Weg, unter der Voraussetzung, dass sich die frequenzabhängigen Verluste irp des Lösungsmittels mit und ohne Ionen nur wenig ändern:

5. Ausführungsbeispiel: Messverfahren bei leitendem Dielektrikum mit signifikanten Raumladungseffekten

Für das nachfolgend dargestellte erfindungsgemäße Verfahren sind lediglich die Gebiete (A) und (B) aus Fig. 4a relevant.
Zur Bestimmung des frequenzmäßigen Übergangs zwischen den Gebieten (A) und (B) wird daher eine qualitative Messung des Kapazitätsverhaltens von Cewp ausgeführt. Man bestimmt dazu, von höheren zu tieferen Frequenzen schreitend, unter Anwendung der Hilfsgrößenmethode die Cewp, um den Frequenzabschnitt zu finden, bei dem ein signifikanter Anstieg der Kapazität Cewp auftritt. Entsprechende Verfahrensschritte sind in Anspruch 6 definiert.
Die Steilheit dieses signifikanten Anstiegs hängt unter anderem von der Ionengröße, Ionenladung, Beweglichkeit, dem verwendeten Lösungsmittel und der Temperatur ab. Da es sich hier nur um eine qualitative Messung von Cewp handelt, reicht dabei die frequenzunabhängige Bestimmung von ie über eine Leitfähigkeitsmessung. Aus dem Leitwert Ge und UCe wird dann ie für das Zeigerdiagramm ermittelt.
Dann bestimmt man die frequenzabhängigen Verluste als Stromgröße irp des Lösungsmittels ohne Ionen, wie vorher beschrieben, mittels Hilfsgrößenmethode (z.B. Hilfswiderstand), bei der gewünschten Messfrequenz. Dabei befindet man sich im ersten Gebiet (A) (siehe Fig. 4a).
Man bestimmt ebenso mittels Hilfsgrößenmethode (z.B. Hilfswiderstand) nun über das Zeigerdiagramm gemäß Fig. 4d1 den gesamten Verluststrom sB = jrp + irp + iRH für Lösungsmittel mit Ionen bei dieser Messfrequenz. Es ergibt sich dann der gesuchte Ionenleitungsstrom jrp aus:

$$jrp = sB - (irp + iRH).$$

Ebenso kann aus dem Zeigerdiagramm Fig. 4d1 für diese Messfrequenz im Gebiet (A) Cewp bestimmt werden. Entsprechende Verfahrensschritte sind in Anspruch 7 definiert.
Bewegt man sich nun mit der Messfrequenz weiter zu niedrigen Frequenzen, gelangt man in das erwähnte zweite Gebiet (B) (siehe Fig. 4a). Es zeichnet sich physikalisch dadurch aus, dass der Strom der Ionenleitung abnimmt, indem ein Teil von ihm zum kapazitiven Polarisationsstrom iCpol wird. D.h. in diesem Frequenzbereich tritt auf Grund der Raumladung an den Elektroden die zuvor bereits erwähnte Polarisationskapazität Cpol auf.
Um auch in diesem zweiten Gebiet (B) das dielektrische Verhalten messtechnisch bestimmen zu können, werden entsprechende Voraussetzungen wie im ersten Gebiet (A) gemacht, nämlich irp und iCp sollen sich beim Lösungsmittel ohne und mit Ionen bei der Messfrequenz auch im Gebiet (B) kaum ändern.
Man bestimmt also bei der Messfrequenz die Ströme iCp und irp für das Lösungsmittel ohne Ionen mittels Hilfsgrößenmethode.
Als nächstes folgt eine Messung mit Lösungsmittel mit Ionen bei der Messfrequenz. Mittels der Hilfsgrößenmethode wird aus dem Zeigerdiagramm (Fig. 4e1) dann der gesamte kapazitive Strom sA und der gesamte Verluststrom sB bestimmt. Wie im Zeigerdiagramm Fig. 4e1 zu sehen ist, gilt der Zusammenhang:

$$sA = iCp + iCpol ;$$

$$sB = irp + irpol + iRH + jrp - iCpol;$$

irpol ist der frequenzabhängige Verluststrom der Raumladungskapazität. Da der im ersten Gebiet (A) bestimmte Ionenleitungsstrom jrp sich frequenzmäßig kaum ändert, muss nun im zweiten Gebiet (B) von diesem der kapazitive Polarisationsstrom iCpol abgezogen werden. Denn in diesem Gebiet der Raumladung findet, wie angegeben, eine Aufteilung des Ionenstromes in den kapazitiven Polarisationsstrom und in einen verbleibenden Ionenleitungsstrom statt.

Dabei ist: iCpol = sA - iCp; (Hierbei sind sA und iCp bekannt).

Die Polarisationskapazität Cpol wird aus dem Polarisationsstrom iCpol, der Messfrequenz und der allen Messungen zugrunde liegenden gleichen Bezugsspannung UCe des parallelen Ersatzschaltbildes (Fig.4c) bestimmt.

Die Größe des frequenzabhängigen Verluststromes irpol der Raumladungskapazität wird dann gefunden aus:

$$irpol = sB - (irp + jrp + iRH) + iCpol;$$

(Hier sind sB, irp, jrp, iRH und iCpol bekannt).

Die Größe irpol steht in Beziehung mit der Ionenbeweglichkeit bei der entsprechenden Messfrequenz. Die entsprechenden Verfahrensschritte sind Gegenstand des Anspruchs 8.

Damit sind nun für die Gebiete (A) und (B) der Fig. 4a alle Größen ermittelt, die die dielektrischen Eigenschaften des zu untersuchenden Stoffes bestimmen. Mit den zuvor gezeigten erfindungsgemäßen Verfahrensschritten ist es also möglich, auch das frequenzabhängige dielektrische Verhalten von ionenhaltigen Flüssigkeiten mit signifikanten Raumladungseffekten zu ermitteln.

Natürlich besteht auch die Möglichkeit, das im Ausführungsbeispiel 5 erläuterte Verfahren mit einer Hilfskapazität anstelle des Hilfswiderstandes durchzuführen. Die dazu gehörenden Zeigerdiagramme sind in den Figuren 4d2 und 4e2 dargestellt.

Nur aus Gründen der Vollständigkeit sei angemerkt, dass keine signifikanten Änderungen des kapazitiven Verhaltens zu erwarten sind, wenn man sich weiterhin in das in Fig. 4a gezeigte dritte Gebiet (C) mit sehr tiefen Messfrequenzen bzw. zu Gleichstrom hin bewegt. In diesem Bereich wird das Verhalten des Ionenleitungsstromes durch Diffusionsstrom und die Helmholtzschichten an den Elektroden bestimmt.

Bei der Bestimmung der dielektrischen Größen bei Stoffen mit hoher Ionenleitfähigkeit, insbesondere beim Auftreten von Raumladung, müssen für die Messung die vorher angegeben Voraussetzungen gemacht werden. Zur Bewertung der Messgüte empfiehlt es sich, diese Voraussetzungen zu prüfen.

Prüfung der getroffenen Voraussetzungen mittels zusätzlicher Messungen

a) Betrachtung des kapazitiven Stromes iCp

Im Gebiet (A) kann der kapazitive Strom iCp genau ermittelt werden. Durch Vergleich mit iCp des Lösungsmittels ohne Ionen kann man eine Vorstellung darüber gewinnen, ob das Verhalten des zugehörigen Mischdielektrikums - also dann mit Ionen - stärker von dem Dielektrikum ohne Ionen abweicht. Ist dies der Fall, muss man für das Gebiet (B) die iCp-Werte aus dem Gebiet (A) für die Bestimmung im frequenzmäßig nahen Gebiet (B) heranziehen. Dies ist gerechtfertigt, da im Gebiet (B) das kapazitive Verhalten durch die Raumladung beherrscht wird und die frequenzabhängige Ausrichtung der Dipole eine untergeordnete Rolle spielt.

b) Betrachtung des frequenzabhängigen Verluststroms irp

In welchem Maße der frequenzabhängige Verluststrom durch Ionen beeinflusst wird, hängt unter anderem von der Konzentration, der Hydrathülle und der Ladungszahl der Ionen ab. Eine tentative Bewertung könnte man aus der Bedingung ableiten, dass der Verlustwinkel mit und ohne Ionen der mit diesem Dielektrikum gefüllten Kapazität keine wesentliche Änderung erfährt. Alternativ wäre eine aufwendige Leitfähigkeitsmessung - gegebenenfalls mit Wechselspannung - eine Möglichkeit.

Anwendung eines Schutzringkondensators

Die noch verbleibende Aufgabe bei der Bestimmung des Absolutwertes der Dielektrizitätskonstante $\varepsilon$ besteht darin, die Randfelder des durch die Elektroden der Messzelle entstehenden Plattenkondensators Cewp aus der Berechnung zu eliminieren. Dies wird üblicherweise durch einen in der Messzelle (3) eingebauten Schutzringkondensator in Form von Schutzringelektroden (2) bewirkt. Diese müssen bei der Kapazitätsmessung mittels Brückenschaltung auf das Potential der Messelektroden abgeglichen werden. Dieser einfache Ansatz zur Randfeldeliminierung ist bei der Stromspannungsmethode des Zeigerdiagramms nicht möglich.

Um hier jedoch mittels Schutzringkondensator die Randfelder beim Bestimmen von Cewp zu eliminieren, geht man von folgender Überlegung aus: Nach Voraussetzung nimmt der in der Messzelle um die Elektroden eingebaute Schutzringkondensator Cs das gesamte nicht parallele Randfeld auf. Damit ist das Feld zwischen den inneren Elektroden (1), als Messelektroden bezeichnet, parallel. Dieser entstehende Kapazitätsteil wird Messkapazität Ce genannt. Es gilt nun, diese Kapazität Ce zu ermitteln und mit der über die Hilfsgrößenmethode ermittelten Parallelkapazität Cewp zu vergleichen. Diese Bestimmung beruht auf folgender Überlegung:

Fig. 5a zeigt die Messkapazität Ce mit parallelen Feldlinien und den Schutzringkondensator Cs, der die Feldlinien des nicht parallelen Streufeldes beinhaltet.

Man führt nun die folgenden drei Kapazitätsmessungen nach der Hilfsgrößenmethode durch und kann dabei mit guter Näherung voraussetzen, dass sich die Feldverläufe von Ce und Cs kaum verändern:

Messung 1 - Ce und Cs sind parallel geschaltet (Fig. 5b):  Man erhält C1 = Ce+Cs;

Messung 2 - Cs ist kurzgeschlossen (Fig. 5c):  Man erhält C2 = Ce+Cr; (Cr ist die auftretende Reihenkapazität)

Messung 3 - Ce ist kurzgeschlossen (Fig. 5d):  Man erhält C3 = Cs+Cr;

Aus den Messgrößen C1, C2 und C3 berechnet sich einfach die Messkapazität Ce mit parallelen Feldlinien:

$$Ce = \tfrac{1}{2} \ * \ (C1+C2-C3);$$

Bei den Messungen ergibt sich, wie beschrieben, aus dem Zeigerdiagramm die Kapazität Cewp, die der Kapazität des Parallel- und Streufelds entspricht. Der Korrekturfaktor k für die $\varepsilon$-Bestimmung ist dann:

$$k = Ce/Cewp;$$

Setzt man voraus, dass sich der Feldverlauf in der Messzelle bei verschiedenen Proben nicht wesentlich ändert, reicht nur eine Bestimmung des Anteils des parallelen Feldverlaufs der Messzelle aus, und er muss nicht bei jeder Probe neu bestimmt werden.

Unter der Annahme, dass die Raumladungskapazität proportional auf Ce und Cs verteilt ist und die Raumladungskapazität bei Cr vernachlässigbar ist, ist der Korrekturfaktor auch für die $\varepsilon$-Bestimmung des Dielektrikums bei Messfrequenzen im Raumladungsbereich gültig.

Schaltung und gerätemäßiger Aufbau der Messeinrichtung

Fig. 6 zeigt links oben die Messzelle (3), welche die Messelektroden (1) und Schutzringelektroden (2) beinhaltet. Der elektrisch leitfähige Stoff (16), dessen dielektrische Eigenschaften bestimmt werden sollen, ist zwischen den Elektroden eingebracht. Die zu messenden Spannungen (UCe1, UCe2, URv, URvG, UCeG, URvH, UW und UG) werden an den Messstellen (4) ermittelt. Auch der Betrag des Wechselstromes (i, i') wird über diese Messstellen (4) ermittelt. Die an die Messzelle (3) anzuschaltenden variablen Elemente (Rv) und (RH,CH, LH) sind in Fig. 6 mit (5) bzw. (6) bezeichnet. Ferner sind eine Gleichspannungsquelle (9) zur Erzeugung von UG und eine Wechselspannungsquelle (10) zur Erzeugung von UW in Fig. 6 dargestellt. Außerdem ist eine Schalteinrichtung (13) zur Cs-Messung vorgesehen. Eine Steuereinheit (12) steuert über die Steuerleitungen (8) die variablen Elemente (5) und (6) sowie die Schalteinrichtung zur Cs-Messung (13). Die Steuereinheit (12) bewirkt außerdem das Einregeln der Gleichspannungsquelle (9) und der Wechselspannungsquelle (10) und die Umschaltung von Gleich- und Wechselspannungsmessung. Dazu ist ein Umschalter (11) vorgesehen. Die Messdaten fließen über die Datenleitungen (7) dem Rechner (14) zu, der mit der Steuereinheit (12) und dem Anzeigeschirm (14) kommuniziert.

Auf dem Rechner läuft ein Programm (Softwarecode) zur Durchführung der Berechnungsschritte zur Ermittlung der Dielektrizitätskonstante aus den gemessenen Größen und dem Zeigerdiagramm nach dem erfindungsgemäßen Verfahren. Die Steuereinheit, die Daten- und Steuerleitungen und der Rechner bilden also ein Datenverarbeitungssystem zur Ausführung des erfindungsgemäßen Verfahrens.

Falls der Rechner über eine entsprechende Hardware mit Schaltkanälen, Steuerbus und A/D-Wandler verfügt, kann die Steuereinheit auch entfallen. Der Rechner übernimmt dann auch die Steuerung der Verfahrensschritte.

Messung bei inhomogener räumlicher Verteilung des leitfähigen Stoffes

Bei einigen leitfähigen Stoffen ist es möglich, dass innerhalb des Stoffes eine Sedimentierung oder Entmischung stattfindet. Durch diese Vorgänge ist der Stoff in der Messzelle nicht mehr homogen verteilt, sondern weist eine inhomogene räumliche Verteilung auf. Dies ist in der Messzelle in Fig. 7 schematisch durch verschiedene Schraffuren dargestellt. Um nun auch die Veränderungen der dielektrischen Eigenschaften über diese verschiedenen räumlichen Schichten messen zu können, werden die Messelektroden (1) in der Höhe gestaffelt. Dies ist in Fig.7a schematisch dargestellt, N1 ist die obere Messelektrode, N2 die mittlere Messelektrode, N3 ist die untere Messelektrode. Auch hier sind Schutzringelektroden (2) vorgesehen. Dabei wird jeweils mit einem Elektrodenpaar, zum Beispiel N2, eine Messung der dielektrischen Eigenschaften einer Schicht durchgeführt, während die anderen Elektroden (N1, N3, 2) als Schutzringelektroden eingesetzt werden. Für eine gemittelte Messung über das gesamte Höhenprofil werden die Elektroden (N1, N2, N3) parallel geschaltet und die äußersten Elektroden (2) als Schutzringelektroden genutzt.

Die Inhomogenität des zu messenden Stoffes muss sich nicht unbedingt in der Vertikalen ändern, es ist auch eine inhomogene Verteilung in andere Richtungen denkbar.
Mit "Höhe" ist deshalb die Richtung gemeint, in der sich die Inhomogenität des zu messenden Stoffes erstreckt. Die Elektroden staffeln sich also in dieser Richtung, dabei kann die Elektrodenanzahl je nach gewünschter räumlicher Auflösung variieren.

Als weitere Ergänzung kann an der Messzelle auch noch eine Trübungsmesseinrichtung vorgesehen sein. Dabei wird beispielsweise mit einer Lichtquelle und einer Photozelle die Trübung des leitfähigen Stoffes (Dielektrikum) gemessen. Werden mehrere Trübungsmessungen unter ausgewählten Parametervariationen (wie z.B. Messzeitpunkt, Umgebungsbedingungen) durchgeführt, so lassen sich Rückschlüsse auf die Inhomogenität des Dielektrikums ziehen.

Literaturverzeichnis

[1] W. Schwerdtfeger:

Elektrische Messtechnik, Teil 2, Wechselstrommesstechnik.

[2] R. Buchner, J. Barthel and J. Stauber:

The dielectric relaxation of water between 0Â° C and 35 Â° C.
Chem. Phys. Lett. 306 (1999) 57-63.

[3] Shinya Ikeda; Hotishi Kumagai, Kozo Nahamura:

Dielectric analysis of food polysaccharides in aqueous solution.
Elsevier Carbohydrate Research 301, 1997, S. 51-59.

[4] Hung-Chi Chang and George Jaffe, für Part II zusätzlich John A. Rider:

Polarization in Electrolytic Solutions Part I: Theory + Part II: Measurements
The Journal of Chemical Physics, Volume 20, Number 7, July 1952.

[5] H.H. Meinke:

Die komplexe Berechnung von Wechselstromschaltungen.
Sammlung Göschen Band 1156/1156a 1957.

[6] R. Holze:

Leitfaden der Elektrochemie, 1998, S. 40-42.

Anhang: Umrechnungsformeln

Allgemein gilt für die Umrechnung einer Serienschaltung R X in eine äquivalente Parallelschaltung Rp Xp (siehe Fig. 8a) gemäß den Formeln 196 und 197 Lit.5, Seite 83:

$$Rp = R + (X^2 / R); \quad \text{(Formel 196)}$$

$$Xp = X + (R^2 / X); \quad \text{(Formel 197)}$$

Allgemein gilt für die Umrechnung einer Parallelschaltung Rp Xp in eine äquivalente Serienschaltung R X (siehe Fig. 8b) gemäß dem Formelpaar 203 aus Lit.5, Seite 85:

$$R = Rp / [1 + (Rp / Xp)^2 ];$$

$$\text{(Formelpaar 203)}$$

$$X = Xp / [1 + (Xp / Rp)^2];$$

Für die Umwandlung Serienschaltung von r und C (Fig. 1a) in die Parallelschaltung aus Cewp und rp (Fig. 1b) setzt man dann
R = r und X = 1/ ($\omega$ C); in die Formeln 196, 197 ein und erhält so

$$Rp = rp \text{ und } Xp = 1/ (\omega \text{ Cewp});$$

$\omega$ ist die Kreisfrequenz.

Für die Umwandlung des parallelen Ersatzschaltbildes (ESBp) aus Fig. 1b in das serielle Ersatzschaltbild (ESBs) aus Fig. 1c setzt man

Rp = (rp Re) / (rp + Re) und Xp = 1/ ($\omega$ Cewp); in das Formelpaar 203 und erhält so:

$$R = re \text{ und } X = 1/ (\omega \text{ Cew});$$

**Patentansprüche**

1. Verfahren zur Messung der dielektrischen Eigenschaften ($\varepsilon$*) von elektrisch leitfähigen Stoffen, wobei der elektrisch leitfähige Stoff zwischen mindestens zwei Elektroden eingebracht ist, umfassend die Verfahrensschritte:

   - Anschließen eines Vorwiderstandes (Rv) an eine der Elektroden
   - Anschließen einer variablen Spannungsquelle (UG, UW) an den Vorwiderstand (Rv) und die zweite Elektrode
   - Einregeln je einer Gleichspannung (UG) und einer Wechselspannung (UW) bei der Messfrequenz durch die variable Spannungsquelle (UG, UW), so dass sich jeweils der gleiche Spannungswert (UCe) über die mindestens zwei Elektroden ergibt
   - Messung der jeweiligen sich dazu einstellenden Spannung (URvG, URv) über dem Vorwiderstand
   - Bestimmung des zugehörigen Gleichstroms (ie) bzw. Wechselstroms (i) aus der jeweiligen Spannung (URvG, URv) über dem Vorwiderstand (Rv) und dem ohmschen Wert des Vorwiderstands (Rv)
   - Bestimmung des Verlustleitwerts (Ge) des Dielektrikums aus dem Gleichstrom (ie) und der Spannung (UCe) an den Elektroden
   - Aufstellen eines Zeigerdiagrammes der komplexen Größen zu den bisher bestimmten Wechselströmen und Wechselspannungen auf Grundlage eines parallelen und/oder seriellen Ersatzschaltbildes
   - Ermittlung der unbekannten Strom- und Spannungsgrößen aus dem Zeigerdiagramm
   - Bestimmung der parallelen Gesamtkapazität (Cewp) aus den Strom- und Spannungsgrößen des Zeigerdiagrammes
   - Ermitteln des frequenzabhängigen Verlustleitwerts (gp) aus den Strom- und Spannungsgrößen des Zeigerdiagrammes
   - Bestimmen des Realteils $\varepsilon'$ der komplexen Dielektrizitätskonstante $\varepsilon$* aus der parallelen Gesamtkapazität (Cewp) und der Geometrie der Anordnung und der Elektroden
   - Bestimmen des Imaginärteils $\varepsilon''$ der komplexen Dielektrizitätskonstante $\varepsilon$* aus der parallelen Gesamtkapazität (Cewp) und dem frequenzabhängigen Verlustleitwert (gp).

2. Verfahren nach Anspruch 1, wobei nach dem Verfahrensschritt "Bestimmung des Verlustleitwertes (Ge) des Dielektrikums" und vor dem Verfahrensschritt "Aufstellen eines Zeigerdiagrammes" die folgenden zusätzlichen Verfahrensschritte zur Ermittlung der Wechselströme für das Zeigerdiagramm durchgeführt werden:

- Zuschalten eines Hilfswiderstandes (RH) parallel zu den mindestens zwei Elektroden
- Einregeln einer zweiten Wechselspannung (UW) durch die variable Spannungsquelle (UW), so dass sich jeweils der gleiche Spannungswert (UCe) über den mindestens zwei Elektroden ergibt, wie vorher beim Einregeln der Gleichspannung (UG) und der ersten Wechselspannung ohne Hilfswiderstand (RH), wobei die erste und die zweite Wechselspannung die gleiche Kreisfrequenz ($\omega$) haben
- Bestimmung des zugehörigen Wechselstroms (i') aus der Spannung (URvH) über dem Vorwiderstand (Rv) und dem Wert des Vorwiderstands (Rv)
- Bestimmung des Stromes (iRH) durch den Hilfswiderstand (RH) aus der Spannung (UCe) zwischen der ersten und der zweiten Elektrode und dem Wert des Hilfswiderstandes (RH)

und wobei das Zeigerdiagramm auf Grundlage eines parallelen Ersatzschaltbildes erstellt wird, und nach dem Verfahrensschritt "Ermittlung der unbekannten Strom- und Spannungsgrößen aus dem Zeigerdiagramm" die Bestimmung der parallelen Kapazität (Cewp) aus dem Strom (iCp), der durch die parallele Kapazität (Cewp) fließt, und der Spannung (UCe) zwischen der ersten und der zweiten Elektrode erfolgt,
sowie der frequenzabhängige Verlustleitwert (gp) aus dem Strom (irp) durch den Verlustwiderstand (rp) und der Spannung (UCe) zwischen der ersten und der zweiten Elektrode ermittelt wird.

3. Verfahren nach Anspruch 1, wobei nach dem Verfahrensschritt "Bestimmung des Verlustleitwertes (Ge) des Dielektrikums" und vor dem Verfahrensschritt "Aufstellen eines Zeigerdiagrammes" die folgenden zusätzlichen Verfahrensschritte zur Ermittlung der Wechselströme für das Zeigerdiagramm durchgeführt werden:

- Zuschalten einer Hilfskapazität (CH) parallel zu den mindestens zwei Elektroden
- Einregeln einer zweiten Wechselspannung (U W) bei der Messfrequenz durch die variable Spannungsquelle (UW), so dass sich jeweils der gleiche Spannungswert (UCe) über den mindestens zwei Elektroden ergibt, wie vorher beim Einregeln der Gleichspannung (UG) und der ersten Wechselspannung ohne Hilfskapazität, wobei die erste und die zweite Wechselspannung die gleiche Kreisfrequenz ($\omega$) haben
- Bestimmung des zugehörigen Wechselstroms (i') aus der Spannung (URvH) über dem Vorwiderstand (Rv) und dem ohmschen Wert des Vorwiderstands (Rv)
- Bestimmung des Stromes (iH) durch die Hilfskapazität (CH) aus der Spannung (UCe) zwischen der ersten und der zweiten Elektrode und dem Wert der Hilfskapazität (CH)

und wobei das Zeigerdiagramm auf Grundlage eines parallelen Ersatzschaltbildes erstellt wird, und nach dem Verfahrensschritt "Ermittlung der unbekannten Strom- und Spannungsgrößen aus dem Zeigerdiagramm" die Bestimmung der parallelen Kapazität (Cewp) aus dem Strom (iCp), der durch die parallele Kapazität (Cewp) fließt, und der Spannung (UCe) zwischen der ersten und der zweiten Elektrode erfolgt,
sowie der frequenzabhängige Verlustleitwert (gp) aus dem Strom (irp) durch den Verlustwiderstand (rp) und der Spannung (UCe) zwischen der ersten und der zweiten Elektrode ermittelt wird.

4. Verfahren nach Anspruch 1, wobei nach dem Verfahrensschritt "Bestimmung des Verlustleitwertes (Ge) des Dielektrikums" und vor dem Verfahrensschritt "Aufstellen eines Zeigerdiagrammes" die folgenden zusätzlichen Verfahrensschritte zur Ermittlung der Wechselströme für das Zeigerdiagramm durchgeführt werden:

- Zuschalten einer variablen Hilfsinduktivität (LH) parallel zu den mindestens zwei Elektroden
- Vergrößern der variablen Hilfsinduktivität (LH), und dabei Nachregeln der variablen Spannungsquelle (UW) bei der Messfrequenz zum Konstanthalten des Spannungswertes (UCe) über den mindestens zwei Elektroden auf dem gleichen Spannungswert wie vorher beim Verfahrensschritt Einregeln der Gleichspannung (UG),
- wobei gleichzeitig der Betrag des Wechselstromes (i) durch die Elektroden und den elektrisch leitfähigen Stoff erfasst wird, solange, bis der Betrag des Wechselstromes (i) ein Minimum durchlaufen und wieder den ursprünglichen Wert (i) erreicht hat, den er vor dem Zuschalten und Vergrößern der variablen Hilfsinduktivität (LH) hatte, dann Ermittlung des zugehörigen Wertes der variablen Hilfsinduktivität (LH)
- Bestimmung des Stromes (iLH) durch die Hilfsinduktivität (LH) aus der Spannung (UCe) zwischen der ersten und der zweiten Elektrode und dem Wert der Hilfsinduktivität (LH)

- Ermitteln des Stromes iCP = ½ iLH

und wobei das Zeigerdiagramm auf Grundlage eines parallelen Ersatzschaltbildes erstellt wird, und nach dem Verfahrensschritt "Ermittlung der unbekannten Strom- und Spannungsgrößen aus dem Zeigerdiagramm" die Bestimmung der parallelen Kapazität (Cewp) aus dem Strom (iCp), der durch die parallele Kapazität (Cewp) fließt, und der Spannung (UCe) zwischen der ersten und der zweiten Elektrode erfolgt,
sowie der frequenzabhängige Verlustleitwert (gp) aus dem Strom (irp) durch den Verlustwiderstand (rp) und der Spannung (UCe) zwischen der ersten und der zweiten Elektrode ermittelt wird.

5. Verfahren nach einem der Ansprüche 1 bis 4, wobei das Aufstellen des Zeigerdiagrammes auf Grundlage eines seriellen Ersatzschaltbildes erfolgt, aus dem die unbekannten Strom- und Spannungsgrößen ermittelt werden, wobei der serielle Gesamtverlustwiderstand (re) und die serielle Gesamtkapazität (Cew) aus dem Zeigerdiagramm ermittelt werden und dann eine Umwandlung des seriellen Ersatzschaltbildes in ein äquivalentes paralleles Ersatzschaltbild erfolgt, mit dem dann die parallele Gesamtkapazität (Cewp) und der frequenzabhängige Verlustleitwert (gp) ermittelt werden.

6. Verfahren nach einem der Ansprüche 2, 3 oder 4, wobei:

- der elektrisch leitfähige Stoff ein überwiegend ionenhaltiger Stoff ist und das Verfahren nach den Ansprüchen 2, 3 oder 4 für mehrere Frequenzen der Wechselspannung (UW) durchgeführt wird,
- wobei von höheren zu tieferen Frequenzen verfahren wird und zu jeder dieser Frequenzen die parallele Gesamtkapazität Cewp ermittelt wird, solange, bis ein signifikanter Anstieg der Kapazität Cewp auftritt,
- und dann ein erstes Frequenzband fA aus dem Frequenzbereich (Gebiet (A)) vor dem signifikanten Anstieg der parallelen Gesamtkapazität Cewp definiert wird und ein zweites Frequenzband fB aus dem Frequenzbereich (Gebiet (B)) nach dem signifikanten Anstieg der parallelen Gesamtkapazität Cewp definiert wird.

7. Verfahren nach Anspruch 6, wobei in einem weiteren Schritt aus dem ersten Frequenzband fA eine Frequenz für die Wechselspannung (UW) ausgewählt wird, mit der dann das Verfahren nach den Ansprüchen 2, 3 oder 4 jeweils für das Lösungsmittel ohne Ionen und den gesamten ionenhaltigen Stoff durchgeführt wird, dann Ermitteln des frequenzabhängigen Verluststromes irp und des Ionenleitungsstroms jrp zur Ermittlung der dielektrischen Eigenschaften des gesamten ionenhaltigen Stoffes in diesem Frequenzband fA.

8. Verfahren nach Anspruch 7, wobei in einem weiteren Schritt aus dem zweiten Frequenzband fB eine Frequenz für die Wechselspannung (UW) ausgewählt wird, mit der dann das Verfahren nach den Ansprüchen 2, 3 oder 4 jeweils für das Lösungsmittel ohne Ionen und den gesamten ionenhaltigen Stoff durchgeführt wird, dann Ermittlung des frequenzabhängigen Verluststroms irp, des kapazitiven Polarisationsstroms iCpol, sowie des Ionenleitungsstromes für das zweite Frequenzband als Differenz aus jrp - iCpol, zur Ermittlung der dielektrischen Eigenschaften des gesamten ionenhaltigen Stoffes in diesem Frequenzband fB.

9. Verfahren nach einem der vorangehenden Ansprüche, wobei die mindestens zwei Elektroden aus mindestens zwei Messelektroden (1) und mindestens zwei Schutzringelektroden (2) bestehen, und wobei zur Eliminierung des Berechnungsfehlers auf Grund der Randfelder der Messelektroden (1) und damit zur Bestimmung der Messkapazität Ce mit rein parallelem Verlauf der elektrischen Feldlinien, also ohne Randfelder, die folgenden zusätzlichen Schritte durchgeführt werden:

- Messung der Kapazität C1 bei einer Parallelschaltung der Messelektroden (1) mit den Schutzringelektroden (2)
- Messung der Kapazität C2 an den Messelektroden (1) bei Kurzschluss der Schutzringelektroden (2)
- Messung der Kapazität C3 an den Schutzringelektroden (2) bei Kurzschluss der Messelektroden (1)
- Berechnung der Messkapazität Ce aus C1, C2 und C3.
- Ermittlung eines Korrekturfaktors k = Ce/Cewp
- Ermittlung der korrigierten Dielektrizitätskonstante $\varepsilon$ aus der Fläche der Messelektrode (1) und dem Abstand der Messelektroden (1) zueinander.

10. Vorrichtung zur Durchführung des Verfahrens nach einem der Ansprüche 1 - 9, wobei die Vorrichtung mindestens zwei Elektroden (1) umfasst, zwischen denen der elektrisch leitfähige Stoff (16) eingebracht ist, **dadurch gekennzeichnet, dass** die Vorrichtung weiterhin umfasst

- einen Vorwiderstand (Rv, 5), welcher eine der Elektroden (1) kontaktiert

- eine variable Spannungsquelle (UG, UW, 9, 10), die den Vorwiderstand (Rv, 5) und die zweite Elektrode (1) kontaktiert und mit der Gleichspannung (UG) und Wechselspannung (UW) einstellbar ist,
- Mittel (7, 8, 12) zum Einregeln je einer Gleichspannung (UG) und einer Wechselspannung (UW) durch die variable Spannungsquelle (UG, UW, 9, 10), so dass sich jeweils der gleiche Spannungswert (UCe) über den mindestens zwei Elektroden (1) ergibt
- Mittel (4) zur Messung der Spannung (URvG, URv) über dem Vorwiderstand (Rv)
- sowie ein Datenverarbeitungssystem (14, 15), das Mittel zur Ausführung des Verfahrens nach einem der Ansprüche 1 - 9 umfasst.

11. Vorrichtung nach Anspruch 10, wobei die Vorrichtung als zusätzliche Hilfsgrösse einen Hilfswiderstand (RH,6) oder eine Hilfskapazität (CH, 6) oder eine variable Hilfsinduktivität (LH, 6) umfasst, wobei die Hilfsgrösse parallel zu den mindestens zwei Elektroden (1) schaltbar ist.

12. Vorrichtung nach Anspruch 10 oder 11, wobei Mittel (4) zur Messung des Betrags des Wechselstromes (i) durch die beiden Elektroden (1) und den elektrisch leitfähigen Stoff (16) vorgesehen sind und die variable Spannungsquelle insbesondere Wechselspannung verschiedener Frequenzen liefern kann, und die Frequenz insbesondere kleiner 10 kHz, besonders bevorzugt kleiner 1 kHz, ist.

13. Vorrichtung nach einem der Ansprüche 10 - 12 mit mehreren in der Höhe gestaffelten Elektroden (N1, N2, N3), um die Veränderungen der dielektrischen Eigenschaften bei Sedimentierung zu messen und/oder wobei eine zusätzliche Einrichtung zur Trübungsmessung des Dielektrikums vorgesehen ist.

14. Vorrichtung nach einem der Ansprüche 10 - 13, wobei die Vorrichtung außerdem wenigstens einen Schutzringkondensator (Cs) umfasst, der aus mindestens zwei Schutzringelektroden (2) gebildet ist.

15. Computerprogramm mit Softwarecode, der so angepasst ist, dass er die Verfahrensschritte des Verfahrens nach einem der Ansprüche 1 - 9 bei Ablauf auf einem Datenverarbeitungssystem (14, 15) ausführt.

$U_r$

$U_C$

r

C

i

Re

Fig. 1a

3

$U_{Ce}$

$i_{Cp}$

Cewp

i

$i_{rp}$

rp

$i_e$

Re

Re = 1/Ge

Fig. 1b

ESBp

UCe

USCe = UW

URv   Ure   UCew

i   Rv   re   Cew

ESBs

Fig. 1c

UCew

Ure

UCe

URv

USCe

i

Fig. 1d

Fig. 1e

Fig. 1f

**Fig. 2a1**

**Fig.2a2**

Fig. 2b1

Fig.2b2

Fig. 2c

Fig. 2d1

**Fig.2d2**

Fig. 3a

Fig. 3b

Fig. 4a

Fig.4b

Fig. 4c

Fig. 4d1

Fig.4d2

Fig. 4e1

**Fig.4e2**

Fig.5a

Fig.5b

Fig.5c

Fig.5d

Fig. 6

**Fig. 7**

**Fig. 8a**

**Fig. 8b**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- GB 2447477 A
- DE 202004006926 U1

**In der Beschreibung aufgeführte Nicht-Patentliteratur**

- *Chem. Phys. Lett.,* 1999, vol. 306, 57-63
- Carbohydrate Research. Elsevier, 1997, vol. 301, 51-59
- *The Journal of Chemical Physics,* Juli 1952, vol. 20 (7
- *Sammlung Göschen,* 1957
- *Leitfaden der Elektrochemie,* 1998, 40-42